(19) Europäisches Patentamt
European Patent Office
Office européen des brevets

(11) **EP 2 458 737 A1**

(12) **EUROPÄISCHE PATENTANMELDUNG**

(43) Veröffentlichungstag:
**30.05.2012 Patentblatt 2012/22**

(51) Int Cl.:
*H03K 17/687* (2006.01)  *H03K 17/06* (2006.01)
*H03K 5/24* (2006.01)  *H03K 17/00* (2006.01)

(21) Anmeldenummer: **10192761.4**

(22) Anmeldetag: **26.11.2010**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Fraunhofer-Gesellschaft zur Förderung der Angewandten Forschung e.V.
80686 München (DE)**

(72) Erfinder:
• **Pollak, Markus
  91058, Erlangen (DE)**
• **Spies, Peter
  91074, Herzogenaurach (DE)**

(74) Vertreter: **Burger, Markus et al
Schoppe Zimmermann
Stöckeler Zinkler & Partner
Postfach 246
82043 Pullach (DE)**

(54) **Diodenersatzschaltung und diese jeweils enthaltende Aufwärtswandlerschaltung, Abwärtswandlerschaltung und Brückengleichrichterschaltung**

(57)    Eine Diodenersatzschaltung (100) weist ein Schalterbauteil (101) auf, das zwischen einem ersten Anschluss (103) der Diodenersatzschaltung und einem zweiten Anschluss (105) der Diodenersatzschaltung geschaltet ist. Weiterhin weist die Diodenersatzschaltung einen ersten Transistor (107) und einen zweiten Transistor (109) auf. Ein Quellenanschluss (111) des ersten Transistors ist mit dem ersten Anschluss (103) der Diodenersatzschaltung gekoppelt und ein Quellenanschluss (113) des zweiten Transistors ist mit dem zweiten Anschluss (105) der Diodenersatzschaltung gekoppelt. Der erste Transistor ist so geschaltet, dass ein an dem Steueranschluss (115) des ersten Transistors anliegendes Potential ($V_{G1}$) einem an dem ersten Anschluss der Diodenersatzschaltung anliegenden Potential ($V_1$) in verschobener Weise folgt. Ein Steueranschluss (117)

des Schalterbauteils ist so mit dem zweiten Transistor (109) gekoppelt, dass eine Schaltstrecke (119) des Schalterbauteils (101), die zwischen dem ersten Anschluss der Diodenersatzschaltung und dem zweiten Anschluss der Diodenersatzschaltung gekoppelt ist, in einen niederohmigen Zustand versetzt wird, wenn eine zwischen dem ersten Anschluss der Diodenersatzschaltung und dem zweiten Anschluss der Diodenersatzschaltung anliegende Potentialdifferenz eine erste Polarität aufweist, und so dass die Schaltstrecke in einen hochohmigen Zustand versetzt wird, wenn die zwischen dem ersten Anschluss der Diodenersatzschaltung und dem zweiten Anschluss der Diodenersatzschaltung anliegende Potentialdifferenz eine zweite, von der ersten Polarität verschiedene Polarität aufweist.

EP 2 458 737 A1

**Beschreibung**

Technisches Gebiet

Ausführungsbeispiele der vorliegenden Erfindung schaffen eine Diodenersatzschaltung, wie sie beispielsweise in einer Gleichrichterschaltung, einer Aufwärtswandlerschaltung, einer Abwärtswandlerschaltung oder einer Brückengleichrichterschaltung Verwendung finden kann.

Hintergrund der Erfindung

Halbleiterdioden sind für den durch sie fließenden elektrischen Strom in nur einer Richtung leitend, und sperrend für die jeweils andere Stromrichtung. Da ihre Kennlinie jedoch einer mathematischen e-Funktion gleicht, können Halbleiterdioden diese Funktion nur nichtideal erfüllen. Dies bedeutet, dass sie je nach Ausführung einen gewissen Spannungsabfall in Durchlassrichtung erzeugen und einen gewissen Leckstrom in Sperrrichtung erzeugen. Speziell entwickelte Dioden mit niedriger Durchlassspannung haben grundsätzlich hohe Leckströme. Die ideale Funktion einer Diode kann deshalb mit einem einzigen Bauteil typischerweise nicht erreicht werden.

Um die unerwünschten Effekte einer Halbleiterdiode zu umgehen, kann man an ihrer Stelle einen Transistor einsetzen. Dieser Transistor kann durch eine Komparatorschaltung abhängig von der Polarität der an ihm anliegenden Spannung ein- und ausgeschaltet werden. Je nach verwendetem Transistortyp kann dadurch der Spannungsabfall in Durchlassrichtung auf wenige Millivolt gesenkt werden. Liegt die Ausgangsspannung des Komparators im Sperrbereich betragsmäßig deutlich unter der Schwellenspannung des Transistors, so können auch im Sperrbereich keine nennenswerten Leckströme auftreten.

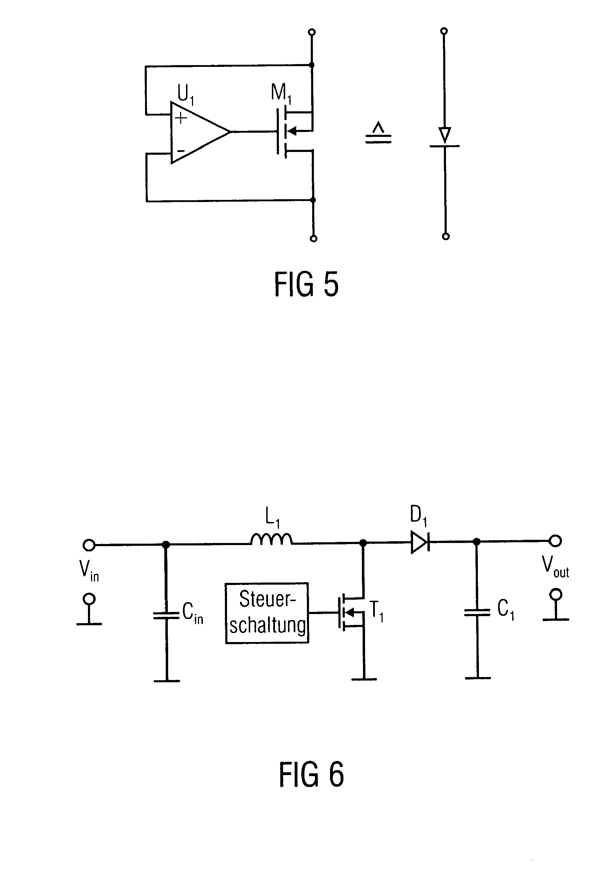

Fig. 5 zeigt ein Schaltbild eines solchen konventionellen Lösungswegs beispielhaft unter Verwendung eines N-Kanal-MOS-Transistors $M_1$ (MOS = metal oxide semiconductor, Metall-Oxid-Halbleiter). Nachteilig kann sich der zusätzliche Schaltungsaufwand gegenüber der Diode als einzelnes Bauteil auswirken. Wird eine hohe Schaltgeschwindigkeit dieser aktiven Diode bzw. Diodenersatzschaltung benötigt, muss auch der Komparator $U_1$ entsprechend steile Flanken für den Steueranschluss des Transistors $M_1$ erzeugen können. Des Weiteren braucht man für den Komparator $U_1$ eine Spannungsversorgung, die sicherstellt, dass der Transistor $M_1$ vollständig ein- und ausgeschaltet werden kann. Dabei ist zu beachten, dass die Ausgangsspannung des Komparators $U_1$ nicht außerhalb seiner Betriebsspannungsgrenzen liegen kann.

Bei Schaltreglem wird typischerweise grundsätzlich mindestens eine Freilaufdiode benötigt, die aufgrund ihrer Kennlinie einen Spannungsabfall im Durchlassbereich verursacht und besonders bei Gleichrichteranwendungen zu Verlustleistungen führt.

Im Folgenden soll das Schaltungskonzept eines konventionellen DC/DC-Aufwärtswandlers (DC/DC = Gleichspannung zu Gleichspannung), wie dargestellt in Fig. 6, betrachtet werden. Ein solcher DC/DC-Aufwärtswandlers wird beispielsweise auch als Sperrwandler bezeichnet, da die Energie in einem Zyklus immer zunächst in der Spule $L_1$ gespeichert und anschließend über die Freilaufdiode $D_1$ an den Ausgangskondensator $C_1$ abgegeben wird. Je nach Ausgangsstrom und Typ der Freilaufdiode $D_1$ führt diese zu mehr oder weniger großen Verlustleistungen durch ihre Vorwärtsspannung. Der in Fig. 6 gezeigte DC/DC-Aufwärtswandler funktioniert so, dass über eine Steuerschaltung ein Transistor $T_1$ ein- und ausgeschaltet wird. Im eingeschalteten Zustand stellt der Transistor $T_1$ eine niederohmige Verbindung zwischen einem Bezugspotentialanschluss (beispielsweise einem Masseanschluss) des DC/DC-Aufwärtswandlers und einem gemeinsamen Anschluss (bzw. Knoten) der Spule $L_1$ und der Freilaufdiode $D_1$ her. In dem eingeschalteten Zustand des Transistors $T_1$ fließt ein Strom durch die Spule $L_1$ wobei der Stromfluss aufgrund der Eingangsspannung des DC/DC Aufwärtswandlers betragsmäßig über der Zeit zunimmt. Wenn der Transistor $T_1$ abgeschaltet wird, so fließt dieser Strom der Spule $L_1$ weiter durch die Freilaufdiode $D_1$ in den Kondensator $C_1$, unabhängig von der an dem Kondensator $C_1$ anliegenden Spannung. Dadurch lässt sich erreichen, dass die an dem Kondensator $C_1$ erreichbare Ausgangsspannung $V_{out}$ größer ist als die an dem Eingang des DC/DC-Aufwärtswandlers anliegende Eingangsspannung $V_{in}$. Die Freilaufdiode $D_1$ dient dazu, dass die in dem Kondensator $C_1$ gespeicherte Energie nicht wieder zurück in die Spule $L_1$ fließen kann.

Es ist möglich, anstatt der Diode $D_1$ auch einen Transistor zu verwenden, der in Abhängigkeit der Schaltzeiten des Transistors $T_1$ angesteuert wird und immer leitet, während die Diode $D_1$ sperrt und umgekehrt. Dies ist die übliche Verfahrensweise bei der Synchrongleichrichtung. Alternativ kann auch die bereits erwähnte Schaltung in Fig. 5 verwendet werden, um die Freilaufdiode $D_1$ zu ersetzen.

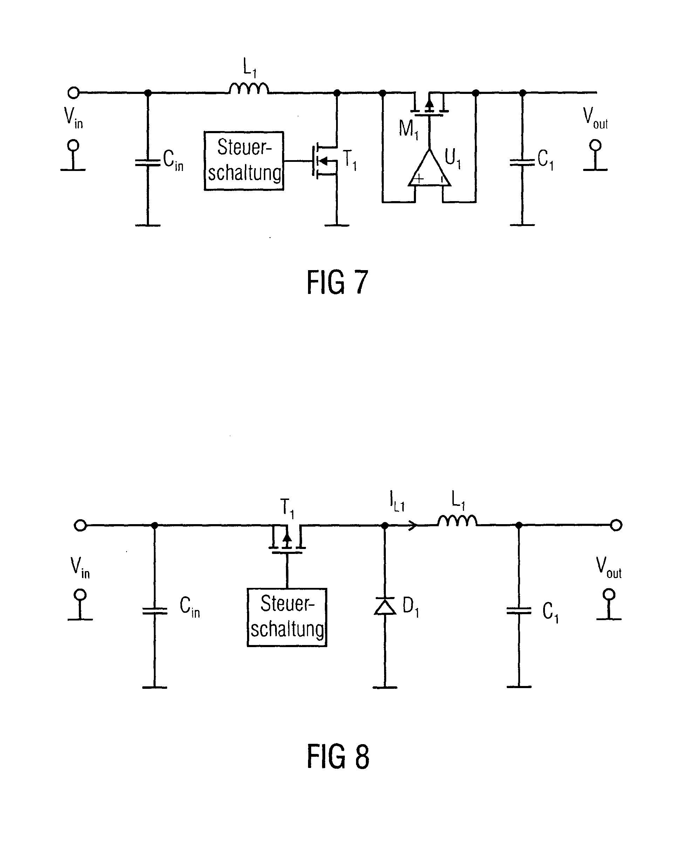

Dies ist in einem Schaltbild in Fig. 7 gezeigt. Es wurde erkannt, dass es entscheidend ist, dass der abgebildete Komparator $U_1$ eine kurze Anstiegszeit aufweist, um den Transistor $M_1$ ausreichend schnell ein- und ausschalten zu können. Ferner wurde erkannt, dass es wichtig ist, dass der Transistor $T_1$ und der Transistor $M_1$ nicht gleichzeitig eingeschaltet sind, um zusätzliche Schaltverluste zu vermeiden. Die in Fig. 7 gezeigte Schaltung bietet daher eine Problemlösung für den Spannungsabfall der Freilaufdiode $D_1$ im Durchlassbereich, welche mit dem Transistor $M_1$ und

der Komparatorschaltung $U_1$ arbeitet, die den Transistor $M_1$ abhängig von der Polarität der anliegenden Spannung ein- und ausschaltet. Der Transistor $M_1$ verhält sich dadurch wie eine Diode mit geringer Durchlassspannung. Jedoch besteht hier der Nachteil, dass eine hohe Schaltgeschwindigkeit des Transistors $M_1$ nur durch einen entsprechend schnellen Komparator realisiert werden kann, welcher einen entsprechenden hohen Stromverbrauch aufweist.

Freilaufdioden können ebenso bei Abwärtswandlern Verwendung finden. Im Folgenden sollen der Aufbau und die Funktionsweise eines in Fig. 8 gezeigten Abwärtswandlers kurz erläutert werden.

Der in Fig. 8 gezeigte Abwärtswandler unterscheidet sich von dem in Fig. 6 gezeigten Aufwärtswandler hauptsächlich dadurch, dass die Freilaufdiode $D_1$ an die Stelle des Schalttransistors $T_1$, der Schalttransistor $T_1$ an die Stelle der Spule $L_1$ und die Spule $L_1$ an die Stelle der Freilaufdiode $D_1$ tritt. Der Abwärtswandler ist ausgebildet, um eine Ausgangsspannung in Abhängigkeit von einer Eingangsspannung bereitzustellen, wobei die Ausgangsspannung kleiner als die Eingangsspannung ist. Der Abwärtswandler funktioniert wie folgt: Während einer Einschaltphase des Schalttransistors $T_1$ (d. h. der Schalttransistor $T_1$ stellt eine niederohmige Verbindung zwischen einem Eingangsanschluss und dem ersten Anschluss der Spule $L_1$ her) fließt ein Laststrom $I_{L1}$ durch die Induktivität $L_1$, welcher zumindest näherungsweise linear ansteigt, die Freilaufdiode $D_1$ ist in Sperrrichtung geschaltet, daher fließt kein Strom durch die Freilaufdiode $D_1$. Wenn der Transistor $T_1$ ausgeschaltet wird (d. h. es besteht eine hochohmige Verbindung zwischen dem ersten Anschluss der Spule $L_1$ und dem Eingangsanschluss des Abwärtswandlers) ist die Diode in Durchlassrichtung geschaltet und die Polarität an der Spule $L_1$ kehrt sich um, wodurch der Spulenstrom $I_{L1}$ abnimmt. Während der Ausschaltphase des Schalttransistors $T_1$ wird die in der Induktivität gespeicherte Energie abgebaut.

Zusammenfassung der Erfindung

Es ist eine Aufgabe der vorliegenden Erfindung, eine Diodenersatzschaltung, die einen guten Kompromiss zwischen Schaltgeschwindigkeit, Schaltungskomplexität und Eigenstromaufnahme mit sich bringt und Schaltungsanordnungen mit einer derartigen Diodenersatzschaltung zu schaffen.

Diese Aufgabe wird gelöst durch eine Diodenersatzschaltung gemäß Anspruch 1, eine Aufwärtswandlerschaltung gemäß Anspruch 17, eine Abwärtswandlerschaltung gemäß Anspruch 19 und eine Brückengleichrichterschaltung gemäß Anspruch 21.

Ausführungsbeispiele der vorliegenden Erfindung schaffen eine Diodenersatzschaltung mit einem Schalterbauteil, das zwischen einen ersten Anschluss der Diodenersatzschaltung und einen zweiten Anschluss der Diodenersatzschaltung geschaltet ist. Weiterhin weist die Diodenersatzschaltung einen ersten Transistor und einen zweiten Transistor auf. Ein Quellenanschluss des ersten Transistors ist mit dem ersten Anschluss der Diodenersatzschaltung gekoppelt. Ein Quellenanschluss des zweiten Transistors ist mit dem zweiten Anschluss der Diodenersatzschaltung gekoppelt. Ein Steueranschluss des ersten Transistors ist mit einem Steueranschluss des zweiten Transistors gekoppelt. Der erste Transistor ist so beschaltet, dass ein an dem Steueranschluss des ersten Transistors anliegendes Potential einem an dem ersten Transistor der Diodenersatzschaltung anliegenden Potential in verschobener Weise folgt. Ein Steueranschluss des Schalterbauteils ist so mit dem zweiten Transistor gekoppelt, dass eine Schaltstrecke des Schalterbauteils, die zwischen den ersten Anschluss der Diodenersatzschaltung und den zweiten Anschluss der Diodenersatzschaltung gekoppelt ist, in einen niederohmigen Zustand versetzt wird, wenn eine zwischen dem ersten Anschluss der Diodenersatzschaltung und dem zweiten Anschluss der Diodenersatzschaltung anliegende Potentialdifferenz eine erste Polarität aufweist, und so, dass die Schaltstrecke in einen hochohmigen Zustand versetzt wird, wenn die zwischen dem ersten Anschluss der Diodenersatzschaltung und dem zweiten Anschluss der Diodenersatzschaltung anliegende Potentialdifferenz eine zweite von der ersten Polarität verschiedene Polarität aufweist.

Es ist eine Idee von Ausführungsbeispielen der vorliegenden Erfindung, dass eine verbesserte Ersatzschaltung für eine Diode geschaffen werden kann, wenn die Funktionalität der Diode durch ein geeignetes Schalterbauteil realisiert wird, das mit Hilfe von zumindest zwei Transistoren gesteuert bzw. aus- und eingeschaltet wird, die in der beschriebenen Weise verschaltet sind. Das Versetzen der Schaltstrecke des Schalterbauteils in den niederohmigen Zustand oder in den hochohmigen Zustand erfolgt dabei in Abhängigkeit von der Potentialdifferenz zwischen dem ersten Anschluss der Diodenersatzschaltung und dem zweiten Anschluss der Diodenersatzschaltung.

So stellt sich an dem ersten Transistor, in Abhängigkeit des Potentials an dem ersten Anschluss der Diodenersatzschaltung das Potential an dem Steueranschluss des ersten Transistors ein. Über die Kopplung der Steueranschlüsse der beiden Transistoren stellt, sich auch an dem Steueranschluss des zweiten Transistors ein Potential ein, welches, wie das Potential an dem Steueranschluss des ersten Transistors, dem Potential am ersten Anschluss der Diodenersatzschaltung in verschobener Weise folgt. Abhängig von der Potentialdifferenz zwischen seinem Steueranschluss und seinem Quellenanschluss wird der zweite Transistor ein- und ausgeschaltet, wobei das Potential an dem Quellenanschluss des zweiten Transistors (aufgrund der Kopplung des Quellenanschlusses des zweiten Transistors mit dem zweiten Anschluss der Diodenersatzschaltung) auf dem Potential an dem zweiten Anschluss der Diodenersatzschaltung basiert. Durch die Kopplung des Schalterbauteils mit dem zweiten Transistor kann, in Abhängigkeit von dem Schaltzustand des zweiten Transistors (und damit in Abhängigkeit von der Potentialdifferenz zwischen dem ersten Anschluss und dem zweiten Anschluss der Diodenersatzschaltung), die Schaltstrecke in den hochohmigen oder niederohmigen Zustand versetzt werden.

Dadurch lässt sich die gewünschte Diodenfunktion realisieren, d. h. dass bei einer ersten Polarität oder bei einem ersten Vorzeichen der an der Diodenersatzschaltung anliegenden Potentialdifferenz die Schaltstrecke des Schalterbauteils in einen niederohmigen Zustand versetzt wird, d. h. die Diodenersatzschaltung wird in Durchlassrichtung betrieben, und bei einer zweiten Polarität oder einem zweiten Vorzeichen der an der Diodenersatzschaltung anliegenden Potentialdifferenz die Schaltstrecke des Schalterbauteils in den hochohmigen Zustand versetzt wird, d. h. die Diodenersatzschaltung wird in Sperrrichtung betrieben. Im Vergleich zu der Nutzung einer Diode entsteht hierbei kein oder nur ein geringfügig kleiner Spannungsabfall an der Schaltstrecke des Schalterbauteils und weiterhin können Leckströme beim Betrieb der Diodenersatzschaltung in Sperrrichtung vermieden werden. Das Schalterbauteil verhält sich daher wie eine Diode mit geringer Durchlassspannung. Weiterhin kann, vor allem im Gegensatz zu dem in Fig. 7 gezeigten Beispiel der Nutzung des Komparators $U_1$ zur Steuerung des Transistors $M_1$, durch die Nutzung der einfachen Verschaltung des ersten Transistors und des zweiten Transistors eine hohe Schaltgeschwindigkeit erreicht werden.

Das Schalterbauteil kann beispielsweise einen Schalttransistor umfassen oder ein Schalttransistor sein. Ein Quellenanschluss des Schalttransistors kann mit dem ersten Anschluss der Diodenersatzschaltung gekoppelt sein und ein Senkenanschluss des Schalttransistors kann mit dem zweiten Anschluss der Diodenersatzschaltung gekoppelt sein. Die Schaltstrecke kann ein Pfad zwischen dem Quellenanschluss des Schalterbauteils und dem Senkenanschluss des Schalterbauteils sein. Durch die Wahl eines Schalttransistors für die Schaltstrecke wird ein geringer Spannungsabfall im Durchlassbereich und eine gute Sperrwirkung im Sperrbereich der Diodenersatzschaltung ermöglicht. Weiterhin kann durch Verändern eines Potentials an dem Steueranschluss des Schalttransistors eine schnelles Öffnen und Schließen der Schaltstrecke ermöglicht werden.

Der erste Transistor und der zweite Transistor können beispielsweise Feldeffekttransistoren, Metall-Oxid-Halbleiter-Feldeffekttransistoren (MOSFETs) oder Bipolartransistoren.

Ein Quellenanschluss eines Transistors kann beispielsweise ein Source-Anschluss oder ein Emitteranschluss des Transistors sein, ein Senkenanschluss kann beispielsweise ein Drain-Anschluss oder ein Kollektoranschluss des Transistors sein und ein Steueranschluss kann beispielsweise ein Gate-Anschluss oder Basisanschluss des Transistors sein. Die Schaltstrecke des Schalttransistors kann daher beispielsweise eine Drain-Source-Strecke des Schalttransistors oder eine Emitter-Kollektor-Strecke des Schalttransistors bilden. Ein Haupt-Transistorstrom fließt dann typischerweise von dem Quellenanschluss zu dem Senkenanschluss, bzw. umgekehrt.

In der vorliegenden Anmeldung wird unter einer Kopplung eine direkte niederohmige Kopplung und eine indirekte Kopplung mit einem oder mehreren dazwischen geschalteten Bauelementen verstanden, so dass ein Signal an einem zweiten Schaltungsknoten von einem Signal an einem ersten Schaltungsknoten, der mit dem zweiten Schaltungsknoten gekoppelt ist, abhängig ist. Mit anderen Worten können zwischen den zwei miteinander gekoppelten Anschlüssen weitere Bauelemente, insbesondere passive Bauelemente, wie beispielsweise Widerstände oder Kondensatoren (bei Wechselspannungssignalen), oder Schaltstrecken aktiver Bauelemente, wie beispielsweise von Schaltern oder Transistoren, geschaltet sein. Bei miteinander gekoppelten Anschlüssen kann ein Bauteil zwischen diesen Anschlüssen geschaltet sein, muss aber nicht, so das zwei miteinander gekoppelte Anschlüsse auch direkt (d.h. durch eine niederohmige leitende Verbindung) miteinander verbunden sein können.

Weiterhin ist gemäß der vorliegenden Anmeldung ein erster Anschluss mit einem zweiten Anschluss direkt verbunden, wenn ein an dem zweiten Anschluss anliegendes Signal identisch einem an dem ersten Anschluss anliegenden Signal ist, wobei parasitäre Effekte oder geringfügige Verluste aufgrund von Leiterwiderständen außer Betracht bleiben sollen. Zwei direkt miteinander verbundene Anschlüsse sind daher typischerweise über Leiterbahnen oder Drähte verbunden ohne zusätzliche dazwischen geschaltete Bauteile.

In der vorliegenden Anmeldung soll unter einem eingeschalteten Zustand eines Transistors ein Zustand verstanden werden, in dem eine niederohmige Verbindung zwischen dem Quellenanschluss und dem Senkenanschluss des Transistors besteht, unter einem ausgeschalteten Zustand eines Transistors soll ein Zustand verstanden werden, in dem eine hochohmige Verbindung zwischen dem Quellenanschluss und dem Senkenanschluss des Transistors besteht

Gemäß einigen Ausführungsbeispielen kann ein Senkenanschluss des zweiten Transistors mit einem Steueranschluss für die Schaltstrecke des Schalterbauteils gekoppelt sein, derart, dass ein an dem Steueranschluss des Schalterbauteils anliegendes Potential mit einer Zunahme eines zwischen dem Quellenanschluss und dem Senkenanschluss des zweiten Transistors fließenden Stroms zunimmt und dass mit einer Abnahme des zwischen dem Quellenanschluss und dem Senkenanschluss des zweiten Transistors fließenden Stroms das an dem Steueranschluss des Schalterbauteils anliegende Potential abnimmt. Dadurch kann erreicht werden, dass das Versetzen der Schaltstrecke des Schalterbauteils in den hochohmigen oder in den niederohmigen Zustand in Abhängigkeit von einem Transistorstrom des zweiten Transistors zwischen seinem Quellenanschluss und seinem Senkenanschluss gesteuert werden kann. Durch diese Verschaltung können kurze Schaltzeiten realisiert werden, da dieser Transistorstrom schnell durch Variierung einer Potentialdifferenz zwischen einem Steueranschluss des zweiten Transistors und dem Quellenanschluss des zweiten Transistors einstellbar ist. Weiterhin ist vorteilhaft, dass dieser Transistorstrom relativ unabhängig von einer Potentialdifferenz zwischen dem Quellenanschluss des zweiten Transistors, welcher mit dem zweiten Anschluss der Diodenersatzschaltung gekoppelt ist, und dem Senkenanschluss des zweiten Transistors ist.

Gemäß weiteren Ausführungsbeispielen kann der Steueranschluss des ersten Transistors mit dem Senkenanschluss des ersten Transistors gekoppelt sein, beispielsweise derart, dass der erste Transistor als Diode wirkt, um in Abhängigkeit von dem Potential am ersten Anschluss der Diodenersatzschaltung ein Potential am Steueranschluss des zweiten Transistors bereitzustellen. Wie bereits oben erwähnt, folgt das Potential an dem Steueranschluss des ersten Transistors dem Potential an dem ersten Anschluss der Diodenersatzschaltung in verschobener Weise (wobei die Potentialdifferenz zwischen dem ersten Anschluss der Diodenersatzschaltung und dem Steueranschluss des ersten Transistors typischerweise zumindest eine gewisse Abhängigkeit von dem Potential an dem ersten Anschluss der Diodenersatzschaltung aufweist). Dadurch wird eine unaufwändige Steuerung des Schalterbauteils in Abhängigkeit von dem Potential an dem ersten Anschluss der Diodenersatzschaltung ermöglicht.

Figurenkurzbeschreibung

Ausführungsbeispiele der vorliegenden Erfindung werden anhand der beiliegenden Figuren näher erläutert. Es zeigen:

Fig. 1    ein Blockschaltbild einer Diodenersatzschaltung gemäß einem Ausführungs-beispiel;

Fig. 2    ein Schaltbild eines Aufwärtswandlers gemäß einem Ausführungsbeispiel;

Fig. 3    ein Schaltbild eines Abwärtswandlers gemäß einem Ausführungsbeispiel;

Fig. 4    ein Schaltbild eines Brückengleichrichters gemäß einem Ausführungsbeispiel und ein Schaltbild eines dazu entsprechenden Brückengleichrichters unter der Nutzung von konventionellen Dioden;

Fig. 5    ein Schaltbild einer Diodenersatzschaltung mit einem Komparator und einer dazu entsprechenden Diode;

Fig. 6    ein Schaltbild eines Aufwärtswandlers unter Verwendung einer Freilaufdiode;

Fig. 7    ein Schaltbild des Aufwärtswandlers aus Fig. 6, wobei die Freilaufdiode durch eine Komparatorschaltung und einen Transistor ersetzt ist; und

Fig. 8    ein Schaltbild eines Abwärtswandlers.

Detaillierte Beschreibung

Bevor im Folgenden Ausführungsbeispiele der vorliegenden Erfindung anhand der beiliegenden Figuren erläutert werden, wird darauf hingewiesen, dass gleiche Elemente oder Elemente gleicher Funktion mit denselben Bezugszeichen versehen sind und dass auf eine wiederholte Beschreibung dieser Elemente verzichtet wird. Beschreibungen von Elementen mit gleichen Bezugszeichen sind daher untereinander austauschbar.

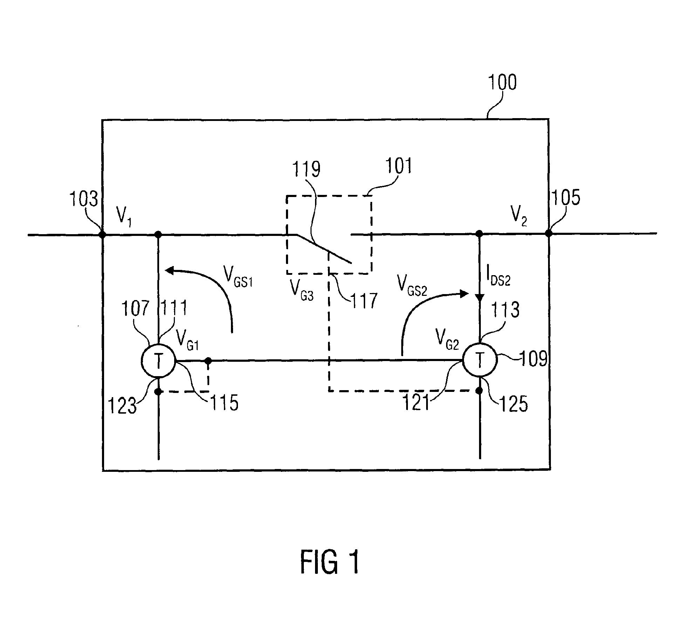

Diodenersatzschaltung gemäß Fig. 1

Fig. 1 zeigt ein Blockschaltbild einer Diodenersatzschaltung 100 gemäß einem Ausführungsbeispiel. Die Diodenersatzschaltung 100 weist ein Schalterbauteil 101 auf, das zwischen einen ersten Anschluss 103 und einen zweiten Anschluss 105 der Diodenersatzschaltung 100 geschaltet ist. Weiterhin weist die Diodenersatzschaltung 100 einen ersten Transistor 107 und einen zweiten Transistor 109 auf. Ein Quellenanschluss 111 (beispielsweise ein Source-Anschluss oder ein Emitteranschluss) des ersten Transistors 107 ist mit dem ersten Anschluss 103 (bzw. einem Knoten der den ersten Anschluss 103 der Diodeneratzschaltung 100 darstellt) der Diodenersatzschaltung 100 gekoppelt. Ein Quellenanschluss 113 (beispielsweise ein Source-Anschluss oder ein Emitteranschluss) des zweiten Transistors 109 ist mit dem zweiten Anschluss 105 (bzw. einem Knoten der den zweiten Anschluss 105 der Diodeneratzschaltung 100 darstellt) der Diodenersatzschaltung 100 gekoppelt. Der erste Transistor 107 ist so beschaltet, dass ein an einem Steueranschluss 115 (beispielsweise ein Gate-Anschluss oder ein Basisanschluss) des ersten Transistors 107 anliegendes Potential $V_{G1}$ einem an dem ersten Anschluss 103 der Diodenersatzschaltung 100 anliegenden Potential $V_1$ in verschobener Weise folgt. Der Steueranschluss 115 des ersten Transistors 107 ist mit einem Steueranschluss 121 (beispielsweise ein Gate-Anschluss oder ein Basisanschluss) des zweiten Transistors 109 gekoppelt. Ein Steueranschluss 117 des Schalterbauteils 101 ist so mit dem zweiten Transistor 109 gekoppelt, dass eine Schaltstrecke 119 des Schalterbauteils 101, die zwischen den ersten Anschluss 103 der Diodenersatzschaltung 100 und dem zweiten Anschluss 105 der Diodenersatzschaltung 100 gekoppelt ist, in einen niederohmigen Zustand versetzt wird, wenn eine zwischen dem ersten Anschluss 103 der Diodenersatzschaltung 100 und dem zweiten Anschluss 105 der Diodenersatzschaltung 100 anliegende Potentialdifferenz ($V_1$ - $V_2$) eine erste Polarität (bzw. ein erstes Vorzeichen, beispielsweise eine positive Polarität oder ein positives Vorzeichen) aufweist, und so, dass die Schaltstrecke 119 in einen hochohmigen Zustand versetzt wird, wenn die zwischen dem ersten Anschluss 103 der Diodenersatzschaltung 100 und dem zweiten Anschluss 105 der Diodenersatzschaltung 100 anliegende Potentialdifferenz eine zweite von der ersten Polarität verschiedene Polarität (bzw. ein zweites Vorzeichen, beispielsweise eine negative Polarität oder ein negatives Vorzeichen) aufweist.

Wie bereits im einleitenden Teil dieser Anmeldung erläutert, kann durch die Nutzung des Schalterbauteils 101 in Verbindung mit den zwei Transistoren 107, 109 eine Diodenersatzschaltung geschaffen werden, welche keinen oder nur einen geringfügig kleinen Spannungsabfall im Durchlassbereich (entlang der Schaltstrecke 119) aufweist. Der in Fig. 5 verwendete Komparator besteht typischerweise aus eine Vielzahl von Transistoren, welche im Zusammenwirken die Komparatorfunktion bewirken. Durch die Nutzung der in Fig. 1 beschriebenen einfachen Verschaltung von nur 2 Transistoren lassen sich, insbesondere im Vergleich zu der in Fig. 5 gezeigten Komparatorschaltung, kurze Schaltzeiten erreichen.

Durch die Kopplung der Quellenanschlüsse 111, 113 der beiden Transistoren 107, 109 mit dem ersten Anschluss 103 bzw. dem zweiten Anschluss 105 der Diodenersatzschaltung 100 kann weiterhin auf eine zusätzliche Spannungsversorgung für die beiden Transistoren 107, 109, wie sie bei dem in Fig. 5 gezeigten Konzept des Komparators benötigt wird, verzichtet werden. Das in der Fig. 1 gezeigte Konzept der Diodenersatzschaltung 100 kommt daher mit weniger Bauelementen als das in Fig. 5 gezeigte Konzept aus und zeichnet sich weiterhin durch die Möglichkeit niedriger Schaltzeiten in Verbindung mit einem geringen Stromverbrauch aus.

Wie in Fig. 1 dargestellt, ist der Steueranschluss 115 des ersten Transistors 107 mit dem Steueranschluss 121 des zweiten Transistors 109 gekoppelt, beispielsweise derart, dass auch ein an dem Steueranschluss 121 anliegendes Potential $V_{G2}$ dem Potential $V_1$ an dem ersten Anschluss 103 der Diodenersatzschaltung 100 folgt. Der Steueranschluss 115 kann beispielsweise direkt mit dem Steueranschluss 121 verbunden sein, so dass

$$V_{G1} = V_{G2}. \qquad\qquad\qquad (1)$$

Durch die Kopplung des Steueranschlusses 115 des ersten Transistors 107 mit dem Steueranschluss 121 des zweiten Transistors 109 wird erreicht, dass das Potential $V_{G2}$ an dem Steueranschluss 121 des zweiten Transistors 109 auf dem Potential $V_1$ an dem ersten Anschluss 103 der Diodenersatzschaltung 100 basiert bzw. in Abhängigkeit von diesem variabel ist. Durch die Kopplung des zweiten Transistors 109 mit dem Steueranschluss 117 für die Schaltstrecke 119 des Schalterbauteils 101 kann dadurch erreicht werden, dass eine Steuerung der Schaltstrecke 119 des Schalterbauteils 101 in Abhängigkeit von dem Potential $V_1$ an dem ersten Anschluss 103 der Diodenersatzschaltung 100, bzw. in Abhängigkeit von einer Differenz zwischen dem Potential $V_1$ an dem ersten Anschluss 103 und dem Potential $V_2$ an dem zweiten Anschluss 105 erfolgt.

Der erste Transistor 107 kann beispielsweise so geschaltet sein, dass dieser als Diode wirkt, um in Abhängigkeit von dem Potential $V_1$ am ersten Anschluss 103 der Diodenersatzschaltung 100 das Potential $V_{G2}$ am Steueranschluss 121 des zweiten Transistors 109 bereitzustellen. Der Transistor 107 kann daher beispielsweise vergleichbar einer zwischen den ersten Anschluss 103 der Diodenersatzschaltung 100 und den Steueranschluss 121 des zweiten Transistors 109 geschalteten Diode sein. Ein über diese Diode entstehender Spannungsabfall wäre vergleichbar mit einer Potentialdifferenz $V_{GS1}$ zwischen dem Quellenanschluss 111 und dem Steueranschluss 115 des ersten Transistors 107 (also beispielsweise vergleichbar einer Gate-Source-Spannung oder einer Basis-Emitter-Spannung). Damit der erste Transistor 107 als Diode wirkt, kann, wie in Fig. 1 gezeigt, der Steueranschluss 115 des ersten Transistors 107 mit einem Senkenanschluss 123 (beispielsweise ein Drain-Anschluss oder ein Kollektoranschluss) des ersten Transistors 107 gekoppelt, beispielsweise direkt verbunden, sein.

Durch die Schaltung des ersten Transistors 107 als Diode zwischen dem ersten Anschluss 103 der Diodenersatzschaltung 100 und dem Steueranschluss 121 des zweiten Transistors 109 wird dem zweiten Transistor 109 das Potential $V_{G2}$ bereitgestellt. Es gilt (abgesehen von parasitären Effekten):

$$V_{G2} \approx V_1 - V_{GS1}. \qquad\qquad (2)$$

Gemäß weiteren Ausführungsbeispielen kann ein Senkenanschluss 125 (beispielsweise ein Drain-Anschluss oder ein Kollektoranschluss) des zweiten Transistors 109, wie in Fig. 1 mit gestrichelten Linien dargestellt, mit dem Steueranschluss 117 für die Schaltstrecke 119 des Schalterbauteils 101 gekoppelt sein, derart, dass ein an dem Steueranschluss 117 des Schalterbauteils 101 anliegendes Potential $V_{G3}$ mit einer Zunahme eines zwischen dem Quellenanschluss 113 und dem Senkenanschluss 125 des zweiten Transistors 109 fließenden Transistorstroms $I_{DS2}$ zunimmt und dass mit einer Abnahme des zwischen dem Quellenanschluss 113 und dem Senkenanschluss 125 des zweiten Transistors 109 fließenden Transistorstroms $I_{DS2}$ das an dem Steueranschluss 117 des Schalterbauteils 101 anliegende Potential $V_{G3}$ abnimmt.

Der zwischen dem Quellenanschluss 113 und dem Senkenanschluss 125 des zweiten Transistors 109 fließende Transistorstrom $I_{DS2}$ kann über das an dem Steueranschluss 121 des zweiten Transistors 109 anliegende Potential $V_{G2}$ eingestellt werden. So lässt sich beispielsweise durch die Nutzung des ersten Transistors 107 als Diode der Transistorstrom $I_{DS2}$ direkt über das an dem ersten Anschluss 103 der Diodenersatzschaltung anliegende Potential $V_1$ einstellen. Das Schalterbauteil 101 kann beispielsweise so ausgebildet sein, dass bei einem vergleichsweise hohen Potential an dem Steueranschluss 117 (bzw. bei einer positiven Potentialdifferenz zwischen dem Steueranschluss 117 und beiden der Anschlüsse 103, 105) des Schalterbauteils 101 die Schaltstrecke 119 in einen hochohmigen Zustand versetzt wird, während bei einem vergleichsweise niedrigen Potential an dem Steueranschluss 117 (bzw. bei einer negativen Potentialdifferenz zwischen dem Steueranschluss 117 und einem der Anschüsse 103, 105) die Schaltstrecke 119 in einen niederohmigen Zustand versetzt wird. Natürlich ist hier auch der umgekehrte Fall möglich, d. h. dass die Schaltstrecke 119 bei einem vergleichsweise hohen Potential an dem Steueranschluss 117 in den niederohmigen Zustand versetzt wird und bei einem vergleichsweise niedrigen Potential an dem Steueranschluss 117 in den hochohmigen Zustand versetzt wird.

In einem Ausführungsbeispiel kann das Schalterbauteil 101 als ein Schalttransistor realisiert sein oder einen Schalttransistor umfassen. Der erste Transistor 107 und der zweite Transistor 109 sowie der Schalttransistor 101 können dabei vom gleichen Typ sein, müssen aber nicht zwangsläufig die gleiche Bauart aufweisen. So können beispielsweise der erste Transistor 107 und der zweite Transistor 109 p-Kanal-Feldeffekttransistoren sein, während der Schalttransistor 101 ein pnp-Bipolartransistor ist. Natürlich kann auch der Schalttransistor 101 ein p-Kanal-Feldeffekttransistor sein. Die Transistoren 107, 109 sowie der Schalttransistor 101 können beispielsweise selbstsperrende Transistoren sein. In dieser Ausführung kann die Diodenersatzschaltung 100 als Ersatz für eine Diode verwendet werden, wobei der erste Anschluss 103 dem Anodenanschluss der Diode entspricht und der zweite Anschluss 105 dem Kathodenanschluss der Diode entspricht.

In einem ersten Zustand, in dem das Potential $V_1$ an dem ersten Anschluss 103 der Diodenersatzschaltung 100 größer ist als das Potential $V_2$ an dem zweiten Anschluss 105 der Diodenersatzschaltung 100 wird über den als Diode wirkenden ersten Transistor 107 ein betragsmäßig hohes positives Potential $V_{G2}$ ($V_{G2} = V_1 - V_{GS1}$) an dem Steueranschluss 121 des zweiten Transistors 109 bereitgestellt. Die dadurch entstehende positive Potentialdifferenz $V_{GS2}$ ($V_{GS2} > 0V$) zwischen dem Steueranschluss 121 und dem Quellenanschluss 113 des zweiten Transistors 109 führt dazu, dass dieser zweite Transistor 109 sperrt, was zu einem niedrigen Potential an dem Senkenanschluss 125 des zweiten Transistors 109 führt. Der Senkenanschluss 125 des zweiten Transistors 109 ist mit dem Steueranschluss 117 des Schalterbauteils 101 gekoppelt. Daher ergibt sich auch an dem Steueranschluss 117 ein niedriges Potential $V_{G3}$ und damit eine betragsmäßig hohe negative Potentialdifferenz $V_{GS3}$ ($V_{GS3} < 0V$) zwischen dem Steueranschluss 117 des Schalttransistors 101 und dem ersten Anschluss 103 der Diodenersatzschaltung 100, wodurch die Schaltstrecke 119 des Schalttransistors 101 in den niederohmigen Zustand versetzt wird.

Ein zweiter Zustand indem ein niedriges Potential $V_1$ ($V_1 < V_2$) an dem ersten Anschluss 103 anliegt, also eine negative Potentialdifferenz $V_1$-$V_2$ entlang der Schaltstrecke 119 besteht, führt dahingegen dazu, dass sich ein hohes Potential $V_{G3}$ an dem Steueranschluss 117 des Schalterbauteils 101 einstellt, wodurch die Schaltstrecke 119 in den hochohmigen Zustand versetzt wird.

Durch das Verhalten in den beiden genannten Zuständen wird die gewünschte Diodenfunktion erreicht. Ein maximal an dem Steueranschluss 117 erreichbares Potential $V_{G3}$ ist gleich dem Potential $V_2$ am zweiten Anschluss 105 der Diodenersatzschaltung 201.

Mit anderen Worten, ausgehend von einem niederohmigen Zustand der Schaltstrecke 119, führt eine Abnahme der Potentialdifferenz $V_{GS2}$ (bzw. eine negative Potentialdifferenz $V_{GS2}$) zwischen dem Steueranschluss 121 des zweiten Transistors 109 und dem Quellenanschluss 113 des zweiten Transistors 109 dazu, dass die Schaltstrecke 119 des Schalterbauteils 101 in den hochohmigen Zustand versetzt wird.

Gemäß einigen Ausführungsbeispielen können die beiden Transistoren 107, 109 in ihren Kenngrößen (bzw. zumindest in ihrer Gate-Source-Schwellspannung oder Basis-Emitter-Flussspannung) identisch gewählt werden. Dies ermöglicht eine einfache Herstellung dieser beiden Transistoren 107, 109, beispielsweise in einem monolithischen Herstellungsprozess. Zudem kann in einigen Ausführungsbeispielen auch das Schalterbauteil 101 vom selben Transistortyp sein wie beiden Transistoren 107, 109 (beispielsweise können das Schalterbauteil 101 und die beiden Transistoren 107, 109 gleiche Gate-Source-Schwellspannungen oder Basis-Emitter-Flussspannungen aufweisen)

Bei weiteren Ausführungsbeispielen kann eine Schwellenspannung oder Flussspannung des ersten Transistors 107 innerhalb eines vorgegebenen Toleranzbereichs gleich einer Schwellenspannung des zweiten Transistors 109 gewählt werden. Der vorgegebene Toleranzbereich kann beispielsweise +/- 50 Millivolt betragen.

Gemäß weiteren Ausführungsbeispielen kann ein Betrag einer Schwellenspannung des ersten Transistors 107 sowie ein Betrag einer Schwellenspannung des zweiten Transistors 109 größer 0, beispielsweise in einem Bereich von 0,3 V - 2 V gewählt werden. Transistoren mit Schwellenspannungen von größer 0 V lassen sich typischerweise einfacher herstellen, was zu geringeren Herstellungskosten für die Diodenersatzschaltung 100 führt als bei Konzepten, in welchen Schwellenspannungen von Transistoren bei 0 V gewählt werden. Die Nutzung solcher Transistoren, bei denen die Schwellenspannung größer 0 V ist, wird ermöglicht durch die in Fig. 1 gezeigte Kopplung der Steueranschlüsse 115, 121 der beiden Transistor 107, 109.

Gemäß weiteren Ausführungsbeispielen können der erste Transistor 107 und der zweite Transistor 109 eine stromspiegelartige Schaltung bilden, bei der das Schalterbauteil 101 zwischen einen Quellenanschluss eines ersten Stromspiegeltransistors (beispielsweise des ersten Transistors 107) und einen Quellenanschluss eines zweiten Stromspiegeltransistors (beispielsweise des zweiten Transistors 109) geschaltet ist, wobei der erste Anschluss 103 der Diodenersatzschaltung 100 mit dem Quellenanschluss des ersten Stromspiegeltransistors gekoppelt ist und wobei der zweite Anschluss 105 der Diodenersatzschaltung 100 mit dem Quellenanschluss des zweiten Stromspiegeltransistors gekoppelt ist.

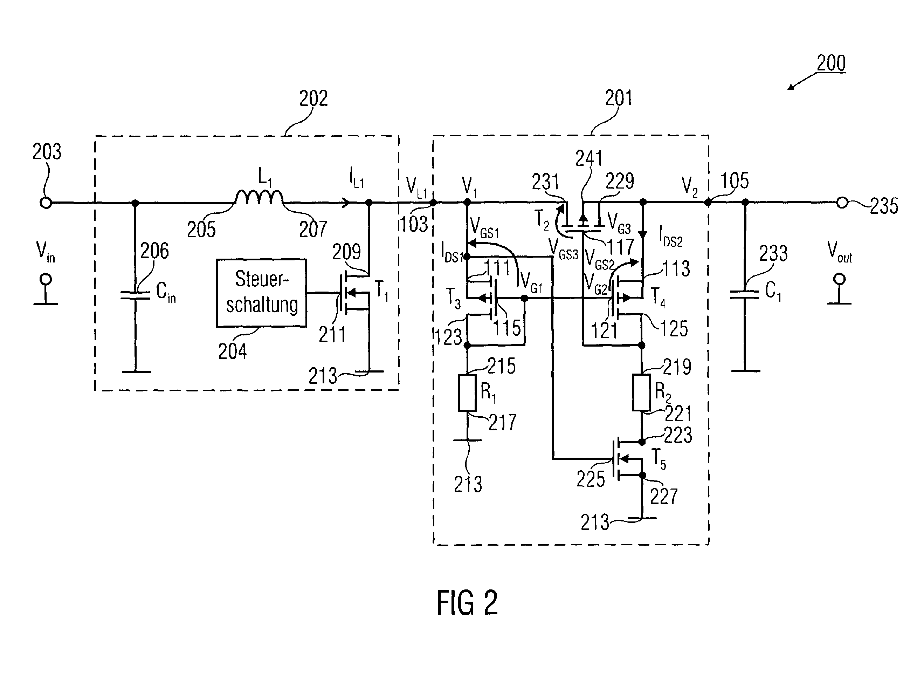

Im Folgenden werden anhand der Fig. 2 - 4 Beispiele beschrieben, in welchen Diodenersatzschaltungen gemäß Ausführungsbeispielen Verwendung finden. In diesen Beispielen sind optionale Merkmale von Diodenersatzschaltungen gezeigt. Diese optionalen Merkmale sind nicht auf die im Folgenden gezeigten Beispiele beschränkt und können als Bestandteile auch weiterer Diodenersatzschaltungen vollständig oder teilweise in anderen Anwendungen verwendet werden. So kann beispielsweise die in Fig. 1 gezeigte Diodenersatzschaltung 100 um die im Folgenden gezeigten optionalen Merkmale oder eine Teilmenge dieser erweitert werden.

Aufwärtswandlerschaltung gemäß Fig. 2

Fig. 2 zeigt ein Schaltbild eines Aufwärtswandlers 200 gemäß einem Ausführungsbeispiel.

Der Aufwärtswandler 200 weist eine Diodenersatzschaltung 201 und eine Energiespeicherschaltung 202 auf. Die Diodenersatzschaltung 201 entspricht in ihrer Funktionalität der in Fig. 1 gezeigten Diodenersatzschaltung 100, wobei die in Fig. 2 gezeigte Diodenersatzschaltung 201 zusätzliche optionale Merkmale gegenüber der in Fig. 1 gezeigten Diodenersatzschaltung 100 aufweist. Die in Fig. 2 gezeigte Aufwärtswandlerschaltung 200 unterscheidet sich von der in Fig. 6 gezeigten Aufwärtswandlerschaltung dadurch, dass die Freilaufdiode $D_1$ durch die Diodenersatzschaltung 201 ersetzt ist. Dementsprechend kann die Energiespeicherschaltung 202 ähnlich oder gleich wie bei dem in Fig. 6 gezeigten Beispiel gewählt werden. Die Energiespeicherschaltung 202 weist eine Spule $L_1$ auf. Weiterhin weist die Energiespeicherschaltung 202 einen (optionalen) Kondensator $C_{in}$, eine Steuerschaltung 204 sowie einen ersten Schalttransistor $T_1$ auf. Ein Eingangsanschluss 203 der Aufwärtswandlerschaltung 200 ist mit einem ersten Anschluss 205 der Spule $L_1$ und einem ersten Anschluss 207 des Eingangskondensators $C_{in}$ gekoppelt. Ein zweiter Anschluss 207 der Spule $L_1$ ist mit einem Senkenanschluss (bzw. einem Drain-Anschluss) 209 des ersten Schalttransistors $T_1$ und mit dem ersten Anschluss 103 der Diodenersatzschaltung 201 gekoppelt. Die Steuerschaltung 204 ist mit einem Steueranschluss 211 (bzw. einem Gate-Anschluss) des ersten Schalttransistors $T_1$ gekoppelt.

Der erste Schalttransistor $T_1$ ist in dem in Fig. 2 gezeigten Ausführungsbeispiel ein n-Kanal-Feldeffekttransistor, beispielsweise ein selbstsperrender n-Kanal-Feldeffekttransistor. Der Schalttransistor $T_1$ ist ausgebildet, um ansprechend auf ein Potential an seinem Steueranschluss 211 eine niederohmige Verbindung zwischen dem zweiten Anschluss 207 der Spule $L_1$ und einem Bezugspotentialanschluss 213 (beispielsweise einem Masseanschluss) der Aufwärtswandlerschaltung 200 bereitzustellen.

Die Diodenersatzschaltung 201 weist einen ersten Transistor $T_3$ auf, welcher dem in Fig. 1 gezeigten ersten Transistor 107 entspricht. Ferner weist die Diodenersatzschaltung 201 einen zweiten Transistor $T_4$ auf, welcher dem in Fig. 1 gezeigten zweiten Transistor 109 entspricht. Weiterhin weist die Diodenersatzschaltung 201 einen zweiten Schalttransistor $T_2$ auf, welcher dem in Fig. 1 gezeigten Schalterbauteil 101 entspricht. In dem in Fig. 2 gezeigten Ausführungsbeispiel sind die beiden Transistoren $T_3$, $T_4$ und der zweite Schalttransistor $T_2$ p-Kanal-MOS-Transistoren bzw. p-Kanal-Feldeffekttransistoren.

Die Schaltstrecke 119 wird daher zwischen einen Senkenanschluss 229 (bzw. einen Drain-Anschluss oder einen ersten Kanalanschluss) und einen Quellenanschluss 231 (bzw. einen Source-Anschluss oder einen zweiten Kanalanschluss) des zweiten Schalttransistors $T_2$ gebildet. Der Quellenanschluss 231 des zweiten Schalttransistors $T_2$ ist mit dem ersten Anschluss 103 der Diodenersatzschaltung 201 gekoppelt und der Senkenanschluss 229 des zweiten Schalttransistors $T_2$ ist mit dem zweiten Anschluss 105 der Diodenersatzschaltung 201 gekoppelt.

Weiterhin weist die Diodenersatzschaltung 201 einen ersten Widerstand $R_1$ auf, wobei ein erster Anschluss 215 des Widerstands $R_1$ mit dem Senkenanschluss 123 des ersten Transistors $T_3$ gekoppelt ist. Ein zweiter Anschluss 217 des ersten Widerstands $R_1$ kann mit dem Bezugspotentialanschluss 213 gekoppelt sein.

Weiterhin weist die Diodenersatzschaltung 201 einen zweiten Widerstand $R_2$ auf, wobei ein erster Anschluss 219 des zweiten Widerstands $R_2$ mit dem Senkenanschluss 125 des zweiten Transistors $T_4$ gekoppelt ist.

Weiterhin ist der Steueranschluss 115 des ersten Transistors $T_3$ mit dem Steueranschluss 121 des zweiten Transistors $T_4$ und dem Senkenanschluss 123 des ersten Transistors $T_3$ gekoppelt. Der Senkenanschluss 125 des zweiten Transistors $T_4$ ist mit dem Steueranschluss 117 des zweiten Schalttransistors $T_2$ gekoppelt.

Ein zwischen dem Quellenanschluss 111 und dem Senkenanschluss 123 des ersten Transistors $T_3$ fließender Transistorstrom $I_{DS1}$ fließt damit auch durch den ersten Widerstand $R_1$ (abgesehen von parasitären Eingangsströmen in die Steueranschlüsse 115, 121 der beiden Transistoren $T_3$, $T_4$). Weiterhin fließt der Transistorstrom $I_{DS2}$ zwischen dem Quellenanschluss 113 und dem Senkenanschluss 125 des zweiten Transistors $T_4$ durch den zweiten Widerstand $R_2$ (abgesehen von einem parasitären Eingangsstrom in den Steueranschluss 117 des zweiten Schalttransistors $T_2$).

Weiterhin weist die Diodenersatzschaltung 201 einen dritten Transistor $T_5$ auf, bei dem es sich um n-Kanal-Feldeffekttransistor handelt. Ein zweiter Anschluss 221 des zweiten Widerstands $R_2$ ist mit einem Senkenanschluss 223 (bzw. einem Drain-Anschluss) des dritten Transistors $T_5$ gekoppelt. Ein Steueranschluss 225 (bzw. ein Gate-Anschluss) des dritten Transistors $T_5$ ist mit dem ersten Anschluss 103 der Diodenersatzschaltung 201 gekoppelt. Ein Quellenanschluss 227 (bzw. ein Source-Anschluss) des dritten Transistors $T_5$ ist mit dem Bezugspotentialanschluss 213 gekoppelt.

In dem in Fig. 2 gezeigten Beispiel ist der dritte Transistor $T_5$ ein selbstsperrender n-Kanal-Feldeffekttransistor. Der dritte Transistor $T_5$ stellt daher bei Anliegen eines ausreichend hohen Potentials an seinem Steueranschluss 225, bzw. bei einer ausreichend großen (positiven) Potentialdifferenz zwischen seinem Steueranschluss 225 und seinem Quellenanschluss 227 eine niederohmige Verbindung zwischen dem Bezugspotentialanschluss 213 und dem zweiten Anschluss 221 des zweiten Widerstands $R_2$ her.

Der dritte Transistor $T_5$ dient dazu, um in einem hochohmigen Zustand der Schaltstrecke des zweiten Schalttransistors $T_2$ einen Querstrom zwischen dem Quellenanschluss 113 und dem Senkenanschluss 125 des zweiten Transistors $T_4$ zu reduzieren oder zu unterdrücken.

In einem weiteren Ausführungsbeispiel kann der dritte Transistor $T_5$ auch weggelassen werden und der zweite Anschluss 221 des zweiten Widerstands $R_2$ direkt mit dem Bezugspotentialanschluss 213 gekoppelt sein, wodurch dann jedoch in dem hochohmigen Zustand der Schaltstrecke des zweiten Schalttransistors $T_2$ ein Querstrom von dem Quellenanschluss 113 zu dem Senkenanschluss 125 des zweiten Transistors $T_4$ (bzw. von dem zweiten Anschluss 105 zu dem Bezugspotentialanschluss 213) entstehen kann.

Die Aufwärtswandlerschaltung 200 weist weiterhin einen Ausgangskondensator $C_1$ auf, wobei ein erster Anschluss 233 des Ausgangskondensators $C_1$ mit einem Ausgangsanschluss 235 sowie dem zweiten Anschluss 105 der Diodenersatzschaltung 201 gekoppelt ist.

Die in Fig. 2 gezeigte Aufwärtswandlerschaltung 200 dient dazu, um eine Ausgangsspannung $V_{out}$ an dem Ausgangsanschluss 235 bereitzustellen, welche größer ist als eine an ihrem Eingangsanschluss 203 anliegende Eingangsspannung $V_{in}$. Die in Fig. 2 gezeigte Aufwärtswandlerschaltung 200 funktioniert wie folgt.

In einer ersten Phase wird der erste Schalttransistor $T_1$ von der Steuerschaltung eingeschaltet, d. h. er stellt eine niederohmige Verbindung zwischen dem Bezugspotentialanschluss 213 und dem zweiten Anschluss 207 der Spule $L_1$ her. Dadurch fließt ein (zeitlich zunehmender) Strom $I_{L1}$ in der Spule von dem Eingangsanschluss 203 und dem Eingangskondensator $C_{in}$.

In einer zweiten Phase wird der erste Schalttransistor $T_1$ von der Steuerschaltung abgeschaltet, d. h. die Verbindung zwischen dem Bezugspotentialanschluss 213 und dem zweiten Anschluss 207 der Spule $L_1$ wird in einen hochohmigen Zustand versetzt, wodurch sich eine Spulenspannung $V_{L1}$, welche größer ist als die Eingangsspannung $V_{in}$ ist, an dem ersten Anschluss 103 der Diodenersatzschaltung 201 einstellt, wobei gilt:

$$V_{L1} = V_1. \tag{3}$$

Dieses erhöhte Potential $V_1$ an dem ersten Anschluss 103 der Diodenersatzschaltung 200 hat zur Folge, dass der dritte Transistor $T_5$ aktiviert wird, also eine niederohmige Verbindung zwischen dem Bezugspotentialanschluss 213 und dem zweiten Anschluss 221 des zweiten Widerstands $R_2$ herstellt. Weiterhin steigen die Potentiale $V_{G1}$, $V_{G2}$ an den Steueranschlüssen 115, 121 der beiden Transistoren $T_3$, $T_4$. Dies wird durch das Zusammenwirken des ersten Transistors $T_3$ und des ersten Wiederstands $R_1$ erzielt. Der erste Transistor $T_3$ wirkt dabei als Diode. Somit liegt das Potential $V_{G1}$ um eine Gate-Source-Spannung $V_{GS1}$ des ersten Transistors $T_3$ unterhalb dem Potential $V_1$ am ersten Anschluss 103. Die Gate-Source-Spannung $V_{GS1}$ des ersten Transistors $T_3$ unterscheidet sich bei geeigneter Dimensionierung von dem ersten Widerstand $R_1$ typischerweise nur wenig von der Schwellenspannung von dem ersten Transistor $T_3$, beispielsweise um nicht mehr als 0.5 Volt. Dies führt dazu, dass eine Gate-Source-Spannung $V_{GS2}$ des zweiten Transistors $T_4$ betragsmäßig klein wird, bzw. das Potential $V_{G2}$ (bzw. das Gate-Potential) des zweiten Transistors $T_4$ sogar oberhalb von dessen Source-Potential liegt. Folglich sinkt der Transistorstrom $I_{DS2}$ des zweiten Transistors $T_4$, wodurch auch das Potential $V_{G3}$ an dem Steueranschluss 117 des zweiten Schalttransistors $T_2$ sinkt und dieser somit eine niederohmige Verbindung zwischen seinem Quellenanschluss 231, also dem ersten Anschluss 103 der Diodenersatzschaltung 200, und seinem Senkenanschluss 229, also dem zweiten Anschluss 105 der Diodenersatzschaltung 200, herstellt. Der Spulenstrom $I_{L1}$ kann daher entlang einer Source-Drain-Strecke des zweiten Schalttransistor $T_2$ fließen, um den Ausgangskondensator $C_1$ aufzuladen. Hierdurch kann an dem Ausgangsanschluss 235 der Aufwärtswandlerschaltung 200 eine gegenüber der Eingangsspannung $V_{in}$ an dem Eingangsanschluss 203 erhöhte Spannung erreicht werden.

Fällt nun das Potential an dem ersten Anschluss 103 der Diodenersatzschaltung 201 ab, beispielsweise so weit, dass $V_1 < V_2$, so sinken auch die Potentiale $V_{G1}$, $V_{G2}$ an den Steueranschlüssen 115, 121 der beiden Transistoren $T_3$, $T_4$. Das Potential $V_{G2}$ an dem Steueranschluss 121 des Transistor T4 kann daher unter einen Wert seines Source-Potentials fallen, so dass sich der Transistorstrom $I_{DS2}$ des zweiten Transistors $T_4$ erhöht, wodurch das Potential $V_{G3}$ an dem Steueranschluss 117 des zweiten Schalttransistors $T_2$ zunimmt und die Schaltstrecke des zweiten Schalttransistors $T_2$ daher in einen hochohmigen Zustand gesetzt wird, d. h. der zweite Schalttransistor $T_2$ sperrt.

Der zweite Schalttransistor T2 ist daher eingeschaltet wenn $V_1 > V_2$ und ausgeschaltet wenn $V_1 < V_2$, was einer Diodenfunktion entspricht. Weiterhin sperrt bei einer weiteren Abnahme des Potentials $V_1$ (beispielsweise wenn $V_1$ ungefähr 0V hat) an dem ersten Anschluss 103 dann auch der dritte Transistor $T_5$, so dass kein Leckstrom über den (leitenden) zweiten Transistor $T_4$ fließen kann.

Mit anderen Worten ist der dritte Transistor $T_5$ ausgebildet, um bei einem ersten Potential an dem ersten Anschluss 103 der Diodenersatzschaltung 200 einen Transistorpfad des dritten Transistors $T_5$ zwischen dem Senkenanschluss 223 des dritten Transistors $T_5$ und dem Quellenanschluss 227 des dritten Transistors $T_5$ in einen niederohmigen Zustand zu versetzen und um bei einem zweitem von dem ersten Potential verschiedenen Potential an dem ersten Anschluss 103 der Diodenersatzschaltung 200 den Transistorpfad des dritten Transistors $T_5$ in einen hochohmigen Zustand zu versetzen.

Über das Verhältnis der beiden Widerstände $R_1$ und $R_2$ können die Schaltpunkte des zweiten Schalttransistors $T_2$ eingestellt werden. Um zu vermeiden, dass der zweite Schalttransistor $T_2$ permanent eingeschaltet wird, bzw. um zu vermeiden dass der zweite Schalttransistor $T_2$ bereits bei $V_1 = V_2$ eingeschaltet wird, kann der zweite Widerstand $R_2$ (bzw. ein Widerstandswert des zweiten Widerstands $R_2$) größer als der erste Widerstand $R_1$ (bzw. als ein Widerstandswert des ersten Widerstands $R_1$) gewählt werden. Dabei kann es vorteilhaft sein, das Widerstandsverhältnis von dem ersten Widerstand $R_1$ (bzw. von dem Widerstandswert des ersten Widerstands $R_1$) und dem zweiten Widerstand $R_2$ (bzw. dem Widerstandswert des zweiten Widerstands $R_2$) so zu wählen, dass der p-Kanal-MOS-Transistor $T_2$ (der zweite Schalttransistor $T_2$) bereits gesperrt ist, sobald die Spannung $V_{L1}$ (an dem ersten Anschluss 103 der Diodenersatzschaltung 200) der Ausgangsspannung $V_{out}$ (an dem Ausgangsanschluss 235) entspricht. Durch die verschiedenen Widerstandswerte der beiden Widerstände $R_1$, $R_2$ kann erreicht werden, dass bei identischen Potentialen an den Steueranschlüssen 115, 121 sich unterschiedliche Drain-Potentiale an ihren Senkenanschlüssen 123, 125 einstellen. Dadurch, dass der zweite Widerstand $R_2$ größer als der erste Widerstand $R_1$ gewählt wird, kann erreicht werden, dass ein Drain-Potential des zweiten Transistors $T_4$ größer ist als ein Drain-Potential des ersten Transistors $T_3$. Dadurch stellt sich ein höheres Potential an dem Senkenanschluss 125 des zweiten Transistors T4, als an den Steueranschlüssen 115, 121 der beiden Transistoren $T_3$, $T_4$, ein und damit auch an dem Steueranschluss 117 des zweiten Schalttransistors $T_2$.

Mit anderen Worten kann ein Widerstandsverhältnis zwischen dem Widerstandswert des ersten Widerstands $R_1$ und dem Widerstandswert des zweiten Widerstands $R_2$ derart gewählt werden, dass sich in einem Betriebszustand, bei dem eine Potentialdifferenz zwischen dem Potential $V_1$ an dem ersten Anschluss 103 der Diodenersatzschaltung 200 und dem Potential $V_2$ an dem zweiten Anschluss 105 der Diodenersatzschaltung 200 zu Null wird, ein derartiges Potential an dem Steueranschluss 117 des zweiten Schalttransistors $T_2$ einstellt, dass die Schaltstrecke des zweiten Schalttransistors $T_2$ in den hochohmigen Zustand versetzt wird.

Der Widerstandswert des zweiten Widerstands $R_2$ kann beispielsweise (wenn der erste Transistor $T_3$ gleich dem zweitem Transistor $T_4$ ist) in einem Bereich von 5 % - 30 % grö-βer gewählt werden als der Widerstandswert des ersten Widerstands $R_1$, so dass in dem Betriebszustand, in dem die Potentialdifferenz zwischen dem Potential $V_1$ an dem ersten Anschluss 103 der Diodenersatzschaltung 200 und dem Potential $V_2$ an dem zweiten Anschluss 105 der Diodenersatzschaltung 200 zu Null wird, ein Potential an dem Senkenanschluss 125 des zweiten Transistors $T_4$ sich weniger von dem Potential an den Anschlüssen 103, 105 der Diodenersatzschaltung 200 unterscheidet als das Potential $V_{G2}$ an dem Steueranschluss 121 des zweiten Transistors $T_4$.

Weiterhin ist der Senkenanschluss 229 des zweiten Schalttransistors $T_2$ mit einem Substratanschluss 241 des zweiten Schalttransistors $T_2$ gekoppelt (bzw. verbunden).

Dadurch, dass der Senkenanschluss 229 bzw. der zweite Kanalanschluss 229 des zweiten Schalttransistors $T_2$ mit dem Substratanschluss 241 des zweiten Schalttransistors $T_2$ verbunden ist, ist zwischen dem Senkenanschluss 229 und dem Quellenanschluss 231 eine "parasitäre" Diode (auch als "Bodydiode" bezeichnet) vorhanden. Eine Kathode der parasitären Diode stellt der Senkenanschluss 229 dar und eine Anode der parasitären Diode stellt der Quellenanschluss 229 dar. Dadurch, dass der Senkenanschluss 229 des zweiten Schalttransistors $T_2$ in Fig. 2 mit dem Knoten 105 (bzw. dem zweiten Anschluss 105) und entsprechend der Quellenanschluss 231 mit dem Knoten 103 (bzw. dem ersten Anschluss 103) verbunden sind, kann sichergestellt werden, dass im Falle $V_1 < V_2$ kein Strom vom Knoten 105 zum Knoten 103 fließt.

Durch die Wahl des Widerstandsverhältnisses zwischen dem Widerstandswert des ersten Widerstands $R_1$ und dem Widerstandswert des zweiten Widerstands $R_2$, wie oben beschrieben, kann erreicht werden, dass eine Potentialdifferenz $V_{GS3}$ zwischen dem Quellenanschluss 231 und dem Steueranschluss 117 des zweiten Schalttransistors $T_2$ betragsmäßig kleiner ist als die Potentialdifferenz $V_{GS1}$ zwischen dem Steueranschluss 115 und dem Quellenanschluss 111 des ersten Transistors $T_3$ und betragsmäßig kleiner als die Potentialdifferenz $V_{GS2}$ zwischen dem Quellenanschluss 113 und dem Steueranschluss 121 des dritten Transistors $T_4$.

Dies ermöglicht eine monolithische Herstellung (beispielsweise mit gleichen Schwellspannungen bzw. Flussspannungen aber ggf. mit verschieden Kanalbreiten bzw. Emitterflächen) der drei Transistoren $T_2$, $T_3$, $T_4$, wobei die drei Transistoren $T_2$, $T_3$, $T_4$ identisch (beispielsweise unter Verwendung identischer Technologieschritte) gefertigt werden können.

Der erste Widerstand $R_1$ kann beispielsweise einen Widerstandswert in einem Bereich von 10 kΩ - 1.000 kΩ aufweisen und ein Widerstandswert des zweiten Widerstands $R_2$ kann in einem Bereich von 5 % - 30 % größer gewählt werden als der Widerstandswert des ersten Widerstands $R_1$. In einem konkreten Ausführungsbeispiel kann der Widerstandswert des ersten Widerstands $R_1$ 100 kΩ betragen und der Widerstandswert des zweiten Widerstands $R_2$ 120 kΩ betragen.

Wie in Fig. 2 gezeigt, kann mit Hilfe der Transistoren $T_3$, $T_4$ ein (besonderer) Komparator unter Verwendung einer abgewandelten Stromspiegelschaltung realisiert werden. Die Ansteuerung des zweiten Schalttransistors $T_2$ erfolgt dabei durch einen (modifizierten) Stromspiegel, dessen Zweige "an seiner Versorgungsspannung" aufgetrennt sind. An diese Stelle tritt der zweite Schalttransistor $T_2$, der die Funktion der im Vorhergehenden gezeigten Freilaufdiode $D_1$ übernehmen soll.

Der dritte Transistor $T_5$ hat in dem Ausführungsbeispiel des DC/DC-Wandlers (der Aufwärtswandlerschaltung 200) die Aufgabe, den Querstrom über den zweiten Transistor $T_4$ zu vermeiden und entsprechend die Verlustleistung zu vermindern. Dies fällt umso mehr ins Gewicht, je kleiner die Energie ist, die am Ausgang 235 des Spannungswandlers (der Aufwärtswandlerschaltung 200) abgegriffen werden soll.

Zusammenfassend zeigt Fig. 2 den Abwärtswandler 200 mit der Energiespeicherschaltung 202 und der Diodenersatzschaltung 201 als Ersatz für die Freilaufdiode $D_1$. Die Energiespeicherschaltung 202 kann beispielsweise identisch wie bei dem in Fig. 6 gezeigten Aufwärtswandler gewählt werden. Die Diodenersatzschaltung 201 ist zwischen den nicht mit dem Eingangsanschluss 203 verbundenen zweiten Anschluss 207 der Spule $L_1$ und den Ausgangsanschluss 235 geschaltet, um als Freilaufdiode zu wirken.

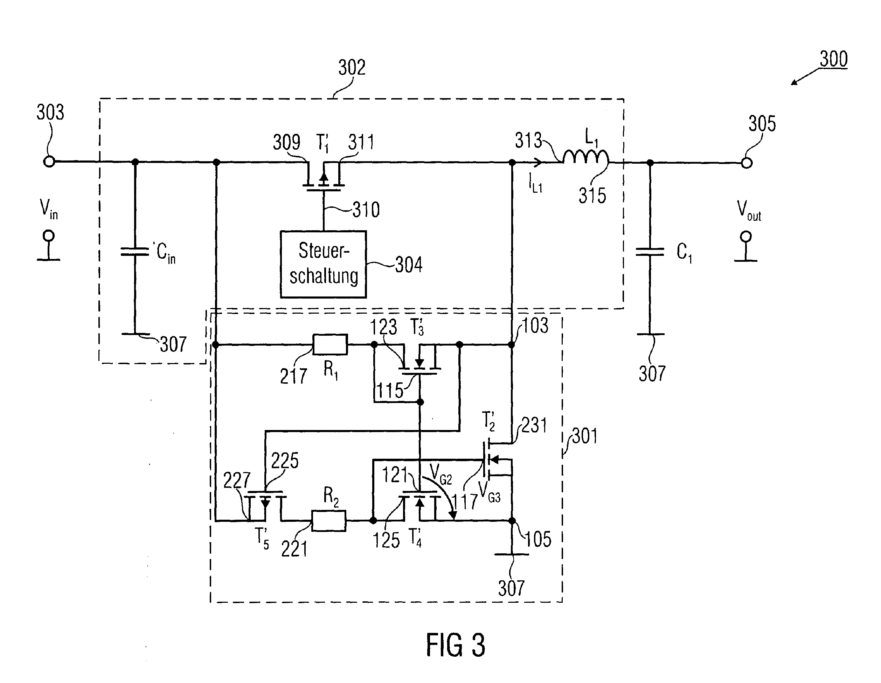

Abwärtswandlerschaltung gemäß Fig. 3

Entsprechend zu der in Fig. 2 gezeigten Aufwärtswandlerschaltung soll im Folgenden die Anwendung der vorliegenden Erfindung auf einen DC/DC-Abwärtswandler gezeigt werden.

Die Grundschaltung eines konventionellen DC/DC-Abwärtswandler ist in Fig. 8 gezeigt und wurde bereits im einleitenden Teil dieser Anmeldung beschrieben.

Fig. 3 zeigt ein Schaltbild einer Abwärtswandlerschaltung 300 gemäß einem Ausführungsbeispiel. Die Abwärtswandlerschaltung 300 weist eine Diodenersatzschaltung 301 und eine Energiespeicherschaltung 302 auf. Die Energiespeicherschaltung 302 des Abwärtswandlers 300 kann beispielsweise identisch oder ähnlich der Energiespeicherschaltung des in Fig. 8 gezeigten Abwärtswandlers gewählt werden. Die Energiespeicherschaltung 302 ist zwischen einen Eingangsanschluss 303 und einen Ausgangsanschluss 305 der Abwärtswandlerschaltung 300 geschaltet. Die Abwärtswandlerschaltung 300 ist ausgebildet, um an ihrem Ausgangsanschluss 305 eine Ausgangsspannung $V_{out}$ basierend auf einer an ihrem Eingangsanschluss 303 anliegenden Eingangsspannung $V_{in}$ bereitzustellen. Die an dem Ausgangsanschluss 305 bereitgestellte Ausgangsspannung $V_{out}$ ist dabei (betragsmäßig) kleiner als die an dem Eingangsanschluss 303 anliegende Eingangsspannung $V_{in}$.

Die Energiespeicherschaltung 302 weist einen zwischen einen Bezugspotentialanschluss 307 der Abwärtswandlerschaltung 300 und den Eingangsanschluss 303 geschalteten (optionalen) Eingangskondensator $C_{in}$ auf. Weiterhin weist die Energiespeicherschaltung 302 einen ersten Schalttransistor $T'_1$ und eine Spule $L_1$ auf. Ein Quellenanschluss 309 des ersten Schalttransistors $T'_1$ ist mit dem Eingangsanschluss 303 gekoppelt. Ein Senkenanschluss 311 des ersten Schalttransistors $T'_1$ ist mit einem ersten Anschluss 313 der Spule $L_1$ gekoppelt. Ein zweiter Anschluss 315 der Spule $L_1$ ist mit dem Ausgangsanschluss 305 gekoppelt. Ferner weist die Abwärtswandlerschaltung 300 einen zwischen ihren Ausgangsanschluss 305 und den Bezugspotentialanschluss 307 gekoppelten Ausgangskondensator $C_1$ auf.

Ferner weist die Energiespeicherschaltung 302 eine Steuerschaltung 304 auf, wobei ein Ausgang der Steuerschaltung 304 mit einem Steueranschluss 310 des ersten Schalttransistors $T'_1$ verbunden ist.

Die Diodenersatzschaltung 301 unterscheidet sich von der in Fig. 2 gezeigten Diodenersatzschaltung 201 dadurch, dass ein erster Transistor $T'_3$, ein zweiter Transistor $T'_4$ und ein zweiter Schalttransistor $T'_2$ n-Kanal-MOSFETs sind (n-Kanal-Metalloxidhalbleiterfeldeffekttransistoren), während die Transistoren $T_2, T_3, T_4$ bei der Diodenersatzschaltung 201 p-Kanal-MOSFETs sind. Weiterhin ist ein dritter Transistor $T'_5$ ein p-Kanal-MOSFET, während der dritte Transistor $T_5$ in der Diodenersatzschaltung 201 ein n-Kanal-MOSFET ist. Die Transistoren $T'_2, T'_3, T'_4, T'_5$ entsprechen in ihrer Verschaltung den Transistoren $T_2, T_3, T_4, T_5$ in der Diodenersatzschaltung 201. Daher werden auch für die Anschlüsse der Transistoren $T'_2 - T'_5$ dieselben Bezugszeichen wie in der Diodenersatzschaltung 201 verwendet, und um Redundanz zu vermeiden, wird die, der Diodenersatzschaltung 301 interne, Verschaltung der Transistoren $T'_2 - T'_5$ nicht nochmals detailliert beschrieben.

Zusätzlich zu der Verwendung komplementärer Transistortypen in der Diodenersatzschaltung 301 gegenüber der Diodenersatzschaltung 201 unterscheidet sich die Verschaltung der Diodenersatzschaltung 301 mit der Energiespeicherschaltung 302 von der Verschaltung der Diodenersatzschaltung 201 mit der Energiespeicherschaltung 202 bei dem Aufwärtswandler 200. So ist ein erster Anschluss 103 der Diodenersatzschaltung 301 mit dem Senkenanschluss 311 des ersten Schalttransistors $T'_1$ und dem ersten Anschluss 313 der Spule $L_1$ gekoppelt. Ein zweiter Anschluss 105 der Diodenersatzschaltung 301 ist mit dem Bezugspotentialanschluss 307 gekoppelt. Wie auch schon bei der Diodenersatzschaltung 201 ist der zweite Schalttransistor $T'_2$ zwischen die beiden Anschlüsse 103, 105 der Diodenersatzschaltung 301 gekoppelt.

Weiterhin ist der zweite Anschluss 217 des ersten Widerstands $R_1$ mit dem Quellenanschluss 227 des dritten Transistors $T'_5$ und dem Eingangsanschluss 303 der Abwärtswandlerschaltung 300 gekoppelt. An dem zweiten Anschluss 217 des ersten Widerstands $R_1$ und an dem Quellenanschluss 227 des dritten Transistors $T'_5$ liegt daher nicht wie bei dem Aufwärtswandler 200 aus Fig. 2 ein Bezugspotential an, sondern die Eingangsspannung $V_{in}$. Weiterhin liegt an dem zweiten Anschluss 105 der Diodenersatzschaltung 301 nicht wie bei dem Aufwärtswandler 200 aus Fig. 2 die Ausgangsspannung $V_{out}$ an, sondern es liegt ein Bezugspotential (beispielsweise eine Massepotential) an.

Im Folgenden soll die Funktionsweise der in Fig. 3 gezeigten Abwärtswandlerschaltung 300 erläutert werden.

In einer ersten Phase schaltet die Steuerschaltung 304, durch Bereitstellen eines entsprechenden Potentials an dem Steueranschluss 310 des ersten Schalttransistors $T'_1$, den Schalttransistor $T'_1$ ein. Dadurch fließt (zeitlich zunehmender) ein Spulenstrom $I_{L_1}$ durch die Spule $L_1$.

Gleichzeitig liegt an dem Quellenanschluss 227 des dritten Transistors $T'_5$ das gleiche Potential wie an einem Steueranschluss 225 des dritten Transistors $T'_5$ an, wodurch der dritte Transistor $T'_5$ aufgrund seiner Eigenschaft als selbstsperrender p-Kanal-MOSFET sperrt. Weiterhin stellt sich an dem Steueranschluss 115 des ersten Transistors $T'_3$ und an dem Steueranschluss 121 des zweiten Transistors $T'_4$ ein gemeinsames positives Potential ein, welches gleich der Eingangsspannung $V_{in}$ ist. Aufgrund der Eigenschaft des zweiten Transistors $T'_4$ wird dieser zweite Transistor $T'_4$ leitend und stellt an dem Steueranschluss 117 des zweiten Schalttransistors $T'_2$ Bezugspotential bereit, wodurch dieser zweite Schalttransistor $T'_2$ ausgeschaltet wird, d. h. er sperrt. Ein Drain-Source-Pfad des zweiten Schalttransistor $T'_2$ ist daher hochohmig und der zweite Schalttransistor $T'_2$ wirkt wie eine Freilaufdiode in Sperrrichtung. Aufgrund der Schaltung des dritten Transistors $T'_5$ zwischen den zweiten Anschluss 221 des zweiten Widerstands $R_2$ und den Eingangsanschluss 303 der Abwärtswandlerschaltung 300 wird ermöglicht, dass in dieser Phase kein Leckstrom von dem Eingangsanschluss 303 über den zweiten Widerstand $R_2$ und den leitenden zweiten Transistor $T'_4$ in den Bezugspotentialanschluss 307 abfließt.

In einer zweiten Phase wird, durch Bereitstellen eines entsprechenden Potentials an dem Steueranschluss 310 des ersten Schalttransistors $T'_1$ von der Steuerschaltung 304 der erste Schalttransistor $T'_1$ abgeschaltet. Dadurch dreht sich die Polarität an dem ersten Anschluss 313 der Spule $L_1$ um. Dieses umgedrehte Potential stellt sich auch an dem Steueranschluss 225 des dritten Transistors $T'_5$ ein, wodurch dieser leitend wird und an dem zweiten Anschluss 221 des zweiten Widerstands $R_2$ die Eingangsspannung $V_{in}$ bereitstellt. Weiterhin folgt das Potential an den Steueranschlüssen 115, 121 der beiden Transistoren $T'_3, T'_4$ dem Potential an dem ersten Anschluss 313 der Spule $L_1$ in verschobener Weise, so dass sich auch an den Steueranschlüssen 115, 121 ein Potential mit umgekehrter Polarität einstellt, so dass der zweite Transistor $T'_4$ sperrt. Dadurch stellt sich an dem Steueranschluss 117 des zweiten Schalttransistors $T'_2$ über den zweiten Widerstand $R_2$ und den dritten Transistor $T'_5$ ein Potential ein, welches gleich der

Eingangsspannung $V_{in}$ ist (abgesehen von parasitären Verlusten über den zweiten Widerstand $R_2$ und den dritten Transistor $T'_5$). Der zweite Schalttransistor $T'_2$ wird daher eingeschaltet und stellt eine niederohmige Verbindung zwischen dem Bezugspotentialanschluss 307 und dem ersten Anschluss 313 der Spule $L_1$ her und wird daher in Durchlassrichtung betrieben. Dies entspricht der Funktion der Freilaufdiode $D_1$ bei der Schaltung gemäß Fig. 8, da in dem Fall, in dem die Spannung an dem ersten Anschluss 313 der Spule $L_1$ kleiner als ein Bezugspotential ist, auch diese Freilaufdiode $D_1$ zu leiten beginnt.

Steigt in dieser Phase das Potential an dem ersten Anschluss 313 der Spule $L_1$ über Bezugspotential, so stellt sich ein positives Potential an den Steueranschlüssen 115, 121, der beiden Transistoren $T'_3$, $T'_4$ ein und damit eine positive Gate-Source-Spannung $V_{GS2}$ des zweiten Transistors $T'_4$. Bei Überschreiten seiner Schwellspannung schaltet der zweite Transistor $T'_4$ ein und stellt an dem Steueranschluss 117 des zweiten Schalttransistors $T'_2$ Bezugspotential bereit. Das Potential $V_{G3}$ an dem Steueranschluss 117 des zweiten Schalttransistors $T'_2$ sinkt damit unter das Potential an dem Quellenanschluss 231 des zweiten Schalttransistors $T'_2$. Der zweite Schalttransistor $T'_2$ wird daher ausgeschaltet und stellt eine hochohmige Verbindung zwischen dem Bezugspotentialanschluss 307 und dem ersten Anschluss 313 der Spule $L_1$ her und wird daher in Sperrrichtung betrieben. Dies entspricht der Funktion der Freilaufdiode $D_1$ bei der Schaltung gemäß Fig. 8, da in dem Fall, in dem die Spannung an dem ersten Anschluss 313 der Spule $L_1$ größer als ein Bezugspotential ist, auch diese Freilaufdiode $D_1$ zu sperren beginnt.

Wie auch schon bei dem in Fig. 2 gezeigten Ausführungsbeispiel können auch hier die Schalt(zeit)punkte für den zweiten Schalttransistor $T'_2$ über das Widerstandsverhältnis der Widerstände $R_1$ zu $R_2$ eingestellt werden.

Weiterhin kann gemäß weiteren Ausführungsbeispielen auch der dritte Transistor $T'_5$ weggelassen werden und der zweite Anschluss 221 des zweiten Widerstands $R_2$ direkt mit dem Eingangsanschluss 303 der Abwärtswandlerschaltung 300 verbunden werden. Dies führt dann allerdings zu Leckströmen in dem Fall, in dem der zweite Transistor $T'_4$ leitend ist.

Aus dem Vergleich der in Fig. 8 gezeigten Abwärtswandlerschaltung und der in Fig. 3 gezeigten Abwärtswandlerschaltung 300 ist ersichtlich, wie die abgewandelte Stromspiegelschaltung bei dem Abwärtswandler 300 eingesetzt werden kann. Hier wird ein n-MOS-Transistor ($T'_2$) als Ersatz für die Freilaufdiode $D_1$ eingesetzt. Weiterhin sind die beiden Transistoren $T'_3$, $T'_4$ n-Kanal-MOSFETs und der dritte Transistor $T'_5$ ein p-MOSFET. Weiterhin ist zu beachten, dass der positive Anschluss des Stromspiegels mit der Eingangsspannung $V_{in}$ verbunden ist.

Obwohl in dem in Fig. 3 gezeigten Ausführungsbeispiel alle Transistoren als Feldeffekttransistoren ausgebildet sind, so können gemäß weiteren Ausführungsbeispielen die Transistoren auch mit Hilfe einer anderen Transistortechnologie realisiert werden. Gemäß einem bevorzugten Ausführungsbeispiel können beispielsweise die Transistoren $T'_3$, $T'_4$ als Bipolartransistoren realisiert sein und der zweite Schalttransistor $T'_2$ kann trotzdem als Feldeffekttransistor realisiert sein. So können die Vorteile beider Technologien in einer Schaltung miteinander vereint werden.

Zusammenfassend zeigt Fig. 3 die Abwärtswandlerschaltung 300 zum Bereitstellen der Ausgangsspannung $V_{out}$ basierend auf der Eingangsspannung $V_{in}$, wobei die Eingangsspannung $V_{in}$ größer ist als die Ausgangsspannung $V_{out}$. Die Abwärtswandlerschaltung 300 kann beispielsweise eine Abwärtssynchrongleichrichterschaltung sein. Die Abwärtswandlerschaltung 300 weist die schaltbare Energiespeicherschaltung 302 und die Diodenersatzschaltung 301 auf. Die schaltbare Energiespeicherschaltung 302 ist zwischen den Ausgangsanschluss 305 zum Bereitstellen der Ausgangsspannung $V_{out}$ und den Eingangsanschluss 303 zum Empfangen der Eingangsspannung $V_{in}$ geschaltet. Der erste Anschluss 103 der Diodenersatzschaltung 301 ist über die Spule $L_1$ (bzw. über die Induktivität $L_1$) der Energiespeicherschaltung 302 mit dem Ausgangsanschluss 305 der Abwärtswandlerschaltung 300 gekoppelt. Der zweite Anschluss 105 der Diodenersatzschaltung 301 ist mit dem Bezugspotentialanschluss 307 (beispielsweise einem Masseanschluss 307) der Abwärtswandlerschaltung 300 gekoppelt. Senkenanschlüsse 123, 125 der beiden Transistoren $T'_3$, $T'_4$ sind (beispielsweise über die Widerstände $R_1$, $R_2$) mit dem Eingangsanschluss 303 der Abwärtswandlerschaltung 300 gekoppelt.

Ferner weist die Diodenersatzschaltung 301 den dritten Transistor $T'_5$ auf, wobei der Steueranschluss 225 des dritten Transistors $T'_5$ mit dem ersten Anschluss 103 der Diodenersatzschaltung gekoppelt (beispielsweise direkt verbunden) ist. Weiterhin ist der zweite Transistor $T'_4$ über den dritten Transistor $T'_5$ (und den zweiten Widerstand $R_2$) mit dem Eingangsanschluss 303 der Abwärtswandlerschaltung 300 gekoppelt.

Da bei den Diodenersatzschaltungen 200, 300 typischerweise ein höherer Strom über die zwei Schalttransistoren $T_2$, $T'_2$ fließt als über die Transistoren $T'_3$ - $T'_4$, kann eine Breite der zweiten Schalttransistoren $T_2$, $T'_2$ um mindestens 50 % größer gewählt werden als die Transistorbreiten der ersten Transistoren $T_3$, $T'_3$ und der zweiten Transistoren $T_4$, $T'_4$.

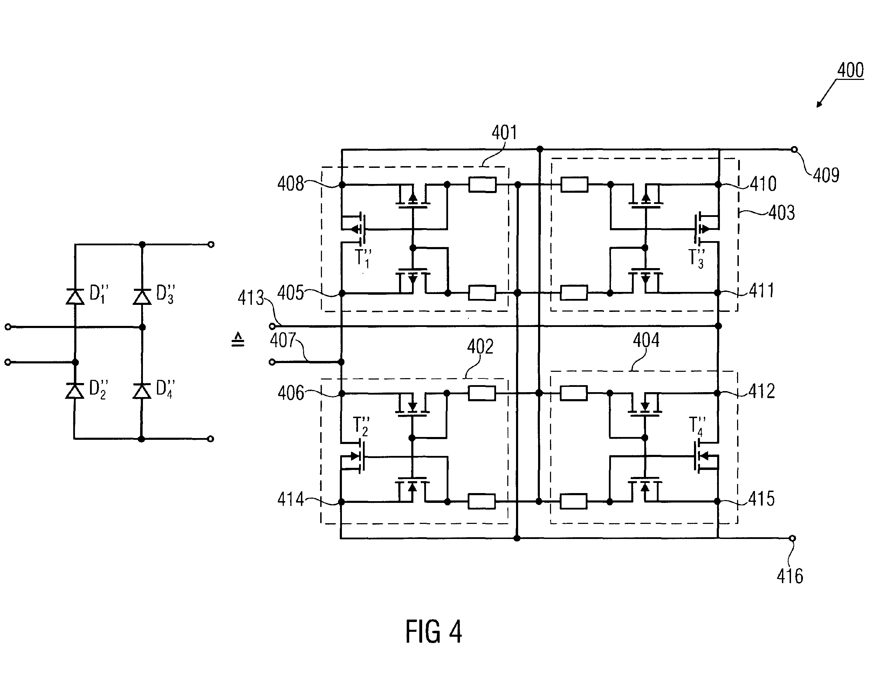

Brückengleichrichterschaltung gemäß Fig. 4

Eine weitere denkbare Anwendung der Diodenersatzschaltung gemäß Ausführungsbeispielen ist ein Brückengleichrichter, beispielsweise für niedrige Eingangsspannungen, wie er in Fig. 4 gezeigt ist.

Fig. 4 zeigt ein Schaltbild einer Brückengleichrichterschaltung 400 gemäß einem Ausführungsbeispiel und einem dazu korrespondierenden konventionellen Brückengleichrichter unter Verwendung von Halbleiterdioden. Bei dem in Fig. 4 gezeigten Beispiel sind Dioden D"$_1$ und D"$_3$ durch p-Kanal-MOS-Transistoren (T"$_1$, T"$_3$)) ersetzt. Dioden D"$_2$ und D"$_4$ sind durch n-Kanal-MOS-Transistoren (T"$_2$, T"$_4$)) ersetzt.

Die Brückengleichrichterschaltung 400 weist daher vier Diodenersatzschaltungen 401, 402, 403, 404 auf. Die Diodenersatzschaltungen 401, 403 weisen p-Kanal-MOS-Transistoren (unter anderem T"$_1$, T"$_3$) auf und die Diodenersatzschaltungen 402, 404 weisen n-Kanal-MOS-Transistoren (unter anderem T"$_2$, T"$_4$) auf. Die Diodenersatzschaltungen 401, 403 sind daher vergleichbar der Diodenersatzschaltung 201 aus Fig. 2, wobei der dritte Transistor T$_5$ hier weggelassen wurde. Die Diodenersatzschaltungen 402, 404 sind vergleichbar der Diodenersatzschaltung 301 aus Fig. 3, wobei der dritte Transistor T'$_5$ weggelassen wurde.

Ein erster Anschluss 405 der ersten Diodenersatzschaltung 401 ist mit einem ersten Anschluss 406 der zweiten Diodenersatzschaltung 402 und einem ersten Eingangsanschluss 407 der Brückengleichrichterschaltung 400 gekoppelt (beispielsweise verbunden oder direkt verbunden). Weiterhin ist ein zweiter Anschluss 408 der ersten Diodenersatzschaltung 401 mit einem ersten Ausgangsanschluss 409 der Brückengleichrichterschaltung 400 und einem zweiten Anschluss 410 der dritten Diodenersatzschaltung 403 gekoppelt (beispielsweise verbunden oder direkt verbunden). Weiterhin ist ein erster Anschluss 411 der dritten Diodenersatzschaltung 403 mit einem ersten Anschluss 412 der vierten Diodenersatzschaltung 404 und einem zweiten Eingangsanschluss 413 der Brückengleichrichterschaltung 400 gekoppelt (beispielsweise verbunden oder direkt verbunden). Weiterhin ist ein zweiter Anschluss 414 der zweiten Diodenersatzschaltung 402 mit einem zweiten Anschluss 415 der vierten Diodenersatzschaltung 404 und einem zweiten Ausgangsanschluss 416 der Brückengleichrichterschaltung 400 gekoppelt (beispielsweise verbunden oder direkt verbunden).

Die Eingangsanschlüsse 407, 413 sowie die Ausgangsanschlüsse 409, 416 der Brückengleichrichterschaltung 400 entsprechen den Eingangs- und Ausgangsanschlüssen der in Fig. 4 gezeigten konventionellen Brückengleichrichterschaltung. Die Brückengleichrichterschaltung 400 funktioniert so, dass bei positiven Eingangsspannungen (d.h. das Potential an dem ersten Eingangsanschluss 407 ist größer als das Potential an dem zweiten Eingangsanschluss 413) der Schalttransistor T"$_1$ der ersten Diodenersatzschaltung 401 sowie der Schalttransistor T"$_4$ der vierten Diodenersatzschaltung 404 leiten. Bei negativen Eingangsspannungen (d.h. das Potential an dem ersten Eingangsanschluss 407 ist kleiner als das Potential an dem zweiten Eingangsanschluss 413) leiten der Schalttransistor T"$_2$ der zweiten Diodenersatzschaltung 402 sowie der Schalttransistor T"$_3$ der dritten Diodenersatzschaltung 403. Die jeweils anderen Schalttransistoren sperren.

Im Folgenden sollen Vorteile von Ausführungsbeispielen der vorliegenden Erfindung zusammengefasst werden.

Die in Verbindung mit Ausführungsbeispielen vorgeschlagene Schaltungsanordnung (beispielsweise die Diodenersatzschaltung 100) hat den Vorteil einer geringen Stromaufnahme, was den Wirkungsgrad der gesamten Wandlerschaltung insbesondere bei kleinen Leistungen erhöhen kann. Außerdem bietet die vorgeschlagene abgewandelte Stromspiegelschaltung den Vorteil einer hohen Schaltgeschwindigkeit, da im Gegensatz zu einem Komparator nur eine einzige Verstärkerstufe ausreichend ist. Des Weiteren sind die Schaltzeitpunkte für die synchrone Gleichrichtung leicht über ein Widerstandsverhältnis (der Widerstände $R_1$, $R_2$) einstellbar.

Bei Ausführungsbeispielen der vorliegenden Erfindung wird ein Transistor (beispielsweise einer der Schalttransistoren $T_2$, T'$_2$) als Ersatz für eine Diode verwendet, wobei der Transistor durch einen abgewandelten Stromspiegel gesteuert wird.

Ausführungsbeispiele der vorliegenden Erfindung sind besonders relevant für den Einsatz bei Spannungswandlern, die für kleine Ausgangsleistungen im Milliwattbereich ausgelegt sind. Hier gehen Verlustleistungen durch die Steuerelektronik für die Schalttransistoren besonders in den Wirkungsgrad des Wandlers ein. Denkbar ist auch ein Einsatz bei Schaltnetzteilen mit Potentialtrennung, da hier die Schalttransistoren ($T_1$/$T_2$, vgl. die Fig. 6 und 7 sowie 4) auf unterschiedlichen Potentialen liegen. Die Steuerelektronik könnte unter Verwendung der erfindungsgemäßen Ansteuerung nur die Kontrolle über den Schalttransistor $T_1$ übernehmen. Die Steuerelektronik müsste also kein potentialfreies Signal für den Schalttransistor $T_2$ bereitstellen.

Ausführungsbeispiele sind im Allgemeinen für jede Schaltungsanordnung interessant, in der die Vorwärtsspannung einer Diode unerwünscht ist. In diesem Zusammenhang sind die Ausführungsbeispiele auch leicht in integrierten Schaltungen einsetzbar.

Ausführungsbeispiele der vorliegenden Erfindung bieten eine einfache und verbessernde Alternative zu einer Komparatorschaltung als Ersatz für eine Freilaufdiode bei gleichzeitig hoher Schaltgeschwindigkeit.

Ausführungsbeispiele der vorliegenden Erfindung stellen eine verbesserte Alternative zur üblichen Synchrongleichrichtung bei DC/DC-Wandlern dar. Ausführungsbeispiele weisen eine abgewandelte Stromspiegelschaltung auf, die einen Leistungstransistor (beispielsweise einen der Schalttransistoren $T_2$, T'$_2$) ansteuert. Ausführungsbeispiele können generell sinnvoll sein bei Schaltungsanordnungen, in denen die Verlustleistung von Dioden vermieden werden soll.

Einige Ausführungsbeispiele schaffen eine Synchrongleichrichtung mit Stromspiegel.

**Patentansprüche**

1. Eine Diodenersatzschaltung mit folgenden Merkmalen:

einem Schalterbauteil (101, $T_2$, $T'_2$, $T''_1$ - $T''_4$), das zwischen einem ersten Anschluss (103, 405, 411, 406, 412) und einem zweiten Anschluss (105, 408, 410, 414, 415) geschaltet ist;
einem ersten Transistor (107, $T_3$, $T'_3$); und
einem zweiten Transistor (109, $T_4$, $T'_4$);
wobei ein Quellenanschluss (111) des ersten Transistors (107, $T_3$, $T'_3$) mit dem ersten Anschluss (103, 405, 411, 406, 412) der Diodenersatzschaltung gekoppelt ist;
wobei ein Quellenanschluss (113) des zweiten Transistors (109, $T_4$, $T'_4$) mit dem zweiten Anschluss (105, 408, 410, 414, 415) der Diodenersatzschaltung gekoppelt ist;
wobei ein Steueranschluss (115) des ersten Transistors (107, $T_3$, $T'_3$) mit einem Steueranschluss (121) des zweiten Transistors (109, $T_4$, $T'_4$) gekoppelt ist;
wobei der erste Transistor (107, $T_3$, $T'_3$) so beschaltet ist, dass ein dem Steueranschluss (115) des ersten Transistors (107, $T_3$, $T'_3$) anliegendes Potential ($V_{G1}$) einem an dem ersten Anschluss (103, 405, 411, 406, 412) anliegenden Potential ($V_1$) in verschobener Weise folgt;
wobei ein Steueranschluss (117) des Schalterbauteils (101, $T_2$, $T'_2$, $T''_1$ - $T''4$) so mit dem zweiten Transistor (109, $T_4$, $T'_4$) gekoppelt ist, dass eine Schaltstrecke (119) des Schalterbauteils (101, $T_2$, $T'_2$, $T''_1$ - $T''_4$), die zwischen dem ersten Anschluss (103, 405, 411, 406, 412) und den zweiten Anschluss (105, 408, 410, 414, 415) der Diodenersatzschaltung gekoppelt ist, in einen niederohmigen Zustand versetzt wird, wenn eine zwischen dem ersten Anschluss (103, 405, 411, 406, 412) und dem zweiten Anschluss (105, 408, 410, 414, 415) der Diodenersatzschaltung anliegende Potentialdifferenz eine erste Polarität aufweist, und so, dass die Schaltstrecke (119) in einen hochohmigen Zustand versetzt wird, wenn die zwischen dem ersten Anschluss (103, 405, 411, 406, 412) der Diodenersatzschaltung und dem zweiten Anschluss (105, 408, 410, 414, 415) der Diodenersatzschaltung anliegende Potentialdifferenz eine zweite, von der ersten Polarität verschiedene Polarität aufweist.

2. Diodenersatzschaltung gemäß Anspruch 1,
wobei ein Senkenanschluss (125) des zweiten Transistors (113, $T_4$, $T'_4$) mit einem Steueranschluss (117) für die Schaltstrecke (119) des Schalterbauteils (101, $T_2$, $T'_2$) gekoppelt ist, derart, dass ausgehend von einem niederohmigen Zustand der Schaltstrecke (119), eine Abnahme einer Potentialdifferenz zwischen dem Steueranschluss (121) des zweiten Transistors (109, $T_4$, $T'_4$) und dem Quellenanschluss (113) des zweiten Transistors (109, $T_4$, $T'_4$) dazu führt, dass die Schaltstrecke (119) des Schalterbauteils (101, $T_2$, $T'_2$) in den hochohmigen Zustand versetzt wird.

3. Diodenersatzschaltung gemäß einem der Ansprüche 1 bis 2,
wobei ein Senkenanschluss (123) des ersten Transistors (107, $T_3$, $T'_3$) mit dem Steueranschluss (115) des ersten Transistors (107, $T_3$, $T'_3$) gekoppelt ist, derart, dass der erste Transistor (107, $T_3$, $T'_{3)}$ als Diode wirkt, um in Abhängigkeit von dem Potential ($V_1$) am ersten Anschluss (103) der Diodenersatzschaltung ein Potential ($V_{G2}$) am Steueranschluss (121) des zweiten Transistors (109, $T_4$, $T'_4$) bereitzustellen.

4. Diodenersatzschaltung gemäß einem der Ansprüche 1 bis 3,
wobei der Steueranschluss (115) des ersten Transistors (107, $T_3$, $T'_3$) direkt mit dem Steueranschluss (121) des zweiten Transistors (109, $T_4$, $T'_4$) verbunden ist, derart, dass ein Potential ($V_{G1}$) an dem Steueranschluss (115) des ersten Transistors (107, $T_3$, $T'_3$) gleich einem Potential ($V_{G2}$) an dem Steueranschluss (121) des zweiten Transistors (109, $T_4$, $T'_4$) ist.

5. Diodenersatzschaltung gemäß einem der Ansprüche 1 bis 4,
ferner aufweisend einen ersten Widerstand ($R_1$), welcher mit einem Senkenanschluss (123) des ersten Transistors ($T_3$, $T'_3$) gekoppelt ist, und einen zweiten Widerstand ($R_2$), welcher mit einem Senkenanschluss (125) des zweiten Transistor ($T_4$, $T'_4$) gekoppelt ist, derart, dass ein zwischen dem Quellenanschluss (111) und dem Senkenanschluss (123) des ersten Transistors ($T_3$, $T'_3$) fließender Transistorstrom ($I_{DS1}$) durch den ersten Widerstand ($R_1$) fließt, und derart, dass ein zwischen dem Quellenanschluss (113) und dem Senkenanschluss (125) des zweiten Transistors ($T_4$, $T'_4$) fließender Transistorstrom ($I_{DS2}$) durch den zweiten Widerstand ($R_2$) fließt.

6. Diodenersatzschaltung gemäß Anspruch 5,
wobei der Senkenanschluss (125) des zweiten Transistors ($T_4$, $T'_4$) mit einem Steueranschluss (117) für die Schaltstrecke des Schaltelements ($T_2$, $T'_2$) gekoppelt ist; und

wobei ein Widerstandsverhältnis zwischen einem Widerstandswert des ersten Widerstands ($R_1$) und einem Widerstandswert des zweiten Widerstands ($R_2$) derart gewählt ist, dass in einem Betriebszustand, bei dem eine Potentialdifferenz zwischen dem Potential ($V_1$) am ersten Anschluss (103) der Diodenersatzschaltung und dem Potential ($V_{G2}$) am zweiten Anschluss (105) der Diodenersatzschaltung zu Null wird, sich ein derartiges Potential ($V_{GS3}$) an dem Steueranschluss (117) des Schalterbauteils ($T_2$, $T'_2$) einstellt, dass die Schaltstrecke in den hochohmigen Zustand versetzt wird.

**7.** Diodenersatzschaltung gemäß einem der Ansprüche 5 oder 6,
wobei ein Widerstandswert des zweiten Widerstands ($R_2$) in einem Bereich von 5 % bis 30 % größer gewählt ist als ein Widerstandswert des ersten Widerstands ($R_1$), so dass in einem Betriebszustand, bei dem eine Potentialdifferenz zwischen dem Potential ($V_1$) an dem ersten Anschluss (103) der Diodenersatzschaltung und dem Potential ($V_2$) an dem zweiten Anschluss (105) der Diodenersatzschaltung zu Null wird, ein Potential an dem Senkenanschluss (125) des zweiten Transistors ($T_4$, $T'_4$) sich weniger von dem Potential ($V_1$, $V_2$) an den Anschlüssen der Diodenersatzschaltung unterscheidet als ein Potential an dem Steueranschluss (121) des zweiten Transistors ($T_4$, $T'_4$).

**8.** Diodenersatzschaltung gemäß einem der Ansprüche 5 bis 7,
wobei der erste Widerstand ($R_1$) einen Widerstandswert in einem Bereich von 10 k$\Omega$ bis 1.000 k$\Omega$ aufweist und wobei ein Widerstandswert des zweiten Widerstands ($R_2$) in einem Bereich von 5 % bis 30 % größer gewählt ist als der Widerstandswert des ersten Widerstands ($R_1$).

**9.** Diodenersatzschaltung gemäß einem der Ansprüche 1 bis 8,
wobei der erste Transistor (107, $T_3$, $T'_3$) und der zweite Transistor (109, $T_4$, $T'_4$) derart gewählt sind, dass eine Schwellenspannung des ersten Transistors (107, $T_3$, $T'_3$) innerhalb eines vorgegebenen Toleranzbereichs gleich einer Schwellenspannung des zweiten Transistors (109, $T_4$, $T'_4$) ist.

**10.** Diodenersatzschaltung gemäß einem der Ansprüche 1 bis 9,
wobei ein Betrag einer Schwellenspannung des ersten Transistors (107, $T_3$, $T'_3$) und ein Betrag einer Schwellenspannung des zweiten Transistor (109, $T_4$, $T'_4$) in einem Bereich von 0,3 bis 2 Volt gewählt sind.

**11.** Diodenersatzschaltung gemäß einem der Ansprüche 1 bis 10,
ferner aufweisend einen dritten Transistor ($T_5$, $T'_5$), wobei ein Senkenanschluss (223) des dritten Transistors ($T_5$, $T'_5$) mit einem Senkenanschluss (125) des zweiten Transistors ($T_4$, $T'_4$) und einem Steueranschluss (117) für die Schaltstrecke des Schalterbauteils ($T_2$, $T'_2$) gekoppelt ist, um in einem hochohmigen Zustand der Schaltstrecke (119) des Schalterbauteils ($T_2$, $T'_2$) einen Querstrom zwischen dem Quellenanschluss (113) und dem Senkenanschluss (125) des zweiten Transistors ($T_4$, $T'_4$) zu reduzieren oder zu unterdrücken.

**12.** Diodenersatzschaltung gemäß Anspruch 11,
wobei ein Steueranschluss (225) des dritten Transistors ($T_5$, $T'_5$) mit dem ersten Anschluss (103) der Diodenersatzschaltung gekoppelt ist, um bei einem ersten Potential an dem ersten Anschluss (103) der Diodenersatzschaltung einen Transistorpfad des dritten Transistors ($T_5$, $T'_5$) zwischen dem Senkenanschluss (223) des dritten Transistors ($T_5$, $T'_5$) und einem Quellenanschluss (227) des dritten Transistors ($T_5$, $T'_5$) in einen niederohmigen Zustand zu versetzen und um bei einem zweiten, von dem ersten Potential verschiedenen Potential an dem ersten Anschluss (103) der Diodenersatzschaltung den Transistorpfad des dritten Transistors ($T_5$, $T'_5$) in einen hochohmigen Zustand zu versetzen.

**13.** Diodenersatzschaltung gemäß einem der Ansprüche 1 bis 12,
wobei das Schalterbauteil ($T_2$, $T'_2$) einen Schalttransistor ($T_2$, $T'_2$) umfasst oder ein Schalttransistor ($T_2$, $T'_2$) ist,
wobei der erste Transistor ($T_3$), der zweite Transistor ($T_4$) und der Schalttransistor ($T_2$) pnp-Bipolartransistoren oder p-Kanal-Feldeffekttransistoren sind; oder
wobei der erste Transistor ($T'_3$), der zweite Transistor ($T'_4$) und der Schalttransistor ($T'_2$) npn-Bipolartransistoren oder n-Kanal-Feldeffekttransistoren sind.

**14.** Diodenersatzschaltung gemäß einem der Ansprüche 1 bis 13,
wobei das Schalterbauteil ($T_2$, $T'_2$) einen Schalttransistor ($T_2$, $T'_2$) umfasst oder ein Schalttransistor ($T_2$, $T'_2$) ist und wobei der erste Transistor ($T_3$, $T'_3$) und der zweite Transistor ($T_4$, $T'_4$) Bipolartransistoren sind und der Schalttransistor ($T_2$, $T'_2$) ein Feldeffekttransistor ist.

**15.** Diodenersatzschaltung gemäß einem der Ansprüche 13 bis 14,

wobei eine Transistorbreite des Schalttransistors ($T_2$, $T'_2$) um mindestens 50 % größer gewählt ist als Transistorbreiten des ersten Transistors ($T_3$, $T'_3$) und des zweiten Transistors ($T_4$, $T'_4$).

**16.** Diodenersatzschaltung gemäß einem der Ansprüche 1 bis 15,
wobei der erste Transistor ($T_3$, $T'_3$) und der zweite Transistor ($T_4$, $T'_4$) eine stromspiegelartige Schaltung bilden, bei der das Schalterbauteil ($T_2$, $T'_2$) zwischen einen Quellenanschluss (111) eines ersten Stromspiegeltransistors ($T_3$, $T'_3$) und einen Quellenanschluss (113) eines zweiten Stromspiegeltransistors ($T_4$, $T'_4$) geschaltet ist; und
wobei der erste Anschluss (103) der Diodenersatzschaltung mit dem Quellenanschluss (111) des ersten Stromspiegeltransistors ($T_3$, $T'_3$) gekoppelt ist und wobei der zweite Anschluss (105) der Diodenersatzschaltung mit dem Quellenanschluss (113) des zweiten Stromspiegeltransistors ($T_4$, $T'_4$) gekoppelt ist.

**17.** Aufwärtswandlerschaltung zum Bereitstellen einer Ausgangsspannung ($V_{out}$) basierend auf einer Eingangsspannung ($V_{in}$), wobei die Ausgangsspannung ($V_{out}$) größer als die Eingangsspannung ($V_{in}$) ist, mit folgenden Merkmalen:

einer schaltbaren Energiespeicherschaltung (202); und
einer Diodenersatzschaltung (201) gemäß einem der Ansprüche 1 bis 16,
wobei die schaltbare Energiespeicherschaltung (202) mit dem ersten Anschluss (103) der Diodenersatzschaltung gekoppelt ist; und
wobei der zweite Anschluss (105) der Diodenersatzschaltung (201) mit einem Ausgangsanschluss (235) der Abwärtswandlerschaltung gekoppelt ist, damit die Diodenersatzschaltung (201) als Freilaufdiode wirkt, um an dem Ausgangsanschluss (235) die Ausgangsspannung ($V_{out}$) bereitzustellen.

**18.** Aufwärtswandlerschaltung gemäß Anspruch 17
wobei die Diodenersatzschaltung (201) einen dritten Transistor ($T_5$) aufweist;
wobei ein Steueranschluss (225) des dritten Transistors ($T_5$) mit dem ersten Anschluss (103) der Diodenersatzschaltung (201) gekoppelt ist; und
wobei der zweite Transistor ($T_4$) über den dritten Transistor ($T_5$) mit einem Bezugspotentialanschluss (213) der Aufwärtswandlerschaltung gekoppelt ist.

**19.** Abwärtswandlerschaltung zum Bereitstellen einer Ausgangsspannung ($V_{out}$) basierend auf einer Eingangsspannung ($V_{in}$), wobei die Eingangsspannung ($V_{in}$) größer ist als die Ausgangsspannung ($V_{out}$), mit folgenden Merkmalen:

einer schaltbaren Energiespeicherschaltung (302); und
einer Diodenersatzschaltung (301) gemäß einem der Ansprüche 1 bis 16,
wobei die schaltbare Energiespeicherschaltung (302) zwischen einen Ausgangsanschluss (305) zum Bereitstellen der Ausgangsspannung ($V_{out}$) der Abwärtswandlerschaltung (300) und einen Eingangsanschluss (303) zum Empfangen der Eingangsspannung ($V_{in}$) der Abwärtswandlerschaltung (300) geschaltet ist;
wobei der erste Anschluss (103) der Diodenersatzschaltung über eine Induktivität ($L_1$) der schaltbaren Energiespeicherschaltung (302) mit dem Ausgangsanschluss (305) der Abwärtswandlerschaltung gekoppelt ist;
wobei der zweite Anschluss (105) der Diodenersatzschaltung mit einem Bezugspotentialanschluss (307) der Abwärtswandlerschaltung gekoppelt ist; und
wobei ein Senkenanschluss (123) des ersten Transistors ($T'_3$) und ein Senkenanschluss (125) des zweiten Transistors ($T'_4$) der Diodenersatzschaltung (301) mit dem Eingangsanschluss (303) der Abwärtswandlerschaltung gekoppelt sind.

**20.** Abwärtswandlerschaltung gemäß Anspruch 19,
wobei die Diodenersatzschaltung (301) einen dritten Transistor ($T'_5$) aufweist;
wobei ein Steueranschluss (225) des dritten Transistors ($T'_5$) mit dem ersten Anschluss (103) der Diodenersatzschaltung (301) gekoppelt ist; und
wobei der zweite Transistor ($T'_4$) über den dritten Transistor ($T'_5$) mit dem Eingangsanschluss (303) der Abwärtswandlerschaltung gekoppelt ist.

**21.** Brückengleichrichterschaltung mit folgenden Merkmalen:

vier Diodenersatzschaltungen (401 - 404) gemäß einem der Ansprüche 1 bis 16,
wobei ein erster Anschluss (405) einer ersten Diodenersatzschaltung (401) der vier Diodenersatzschaltungen mit einem ersten Anschluss (406) einer zweiten Diodenersatzschaltung (402) der vier Diodenersatzschaltungen und einem ersten Eingangsanschluss (407) der Brückengleichrichterschaltung gekoppelt ist;

wobei ein erster Anschluss (411) einer dritten Diodenersatzschaltung (403) der vier Diodenersatzschaltungen mit einem ersten Anschluss (412) einer vierten Diodenersatzschaltung (404) der vier Diodenersatzschaltungen und mit einem zweiten Eingangsanschluss (413) der Brückengleichrichterschaltung (400) gekoppelt ist; wobei ein zweiter Anschluss (408) der ersten Diodenersatzschaltung (401) mit einem zweiten Anschluss (410) der dritten Diodenersatzschaltung (403) und einem ersten Ausgangsanschluss (409) der Brückengleichrichterschaltung gekoppelt ist; und wobei ein zweiter Anschluss (414) der zweiten Diodenersatzschaltung (402) mit einem zweiten Anschluss (415) der vierten Diodenersatzschaltung (404) und einem zweiten Ausgangsanschluss (416) der Brükkengleichrichterschaltung gekoppelt ist.

22. Brückengleichrichterschaltung gemäß Anspruch 21,
wobei Transistoren der ersten Diodenersatzschaltung (401) und der dritten Diodenersatzschaltung (403) p-Kanal-Feldeffekttransistoren oder pnp-Bipolartransistoren sind; und
wobei Transistoren der zweiten Diodenersatzschaltung (402) und der vierten Diodenersatzschaltung (404) n-Kanal-Transistoren oder npn-Bipolartransistoren sind.

FIG 1

FIG 2

EP 2 458 737 A1

FIG 3

FIG 4

EP 2 458 737 A1

FIG 5

FIG 6

EP 2 458 737 A1

FIG 7

FIG 8

24

Europäisches
Patentamt

European
Patent Office

Office européen
des brevets

## EUROPÄISCHER RECHERCHENBERICHT

Nummer der Anmeldung

EP 10 19 2761

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 01/86811 A1 (NMB USA INC [US]) 15. November 2001 (2001-11-15) | 1-10, 13-17, 19,21,22 | INV. H03K17/687 H03K17/06 |
| A | * Abbildung 8 * | 11,12, 18,20 | H03K5/24 |
| | ----- | | ADD. H03K17/00 |

RECHERCHIERTE
SACHGEBIETE (IPC)

H03K

Der vorliegende Recherchenbericht wurde für alle Patentansprüche erstellt

| Recherchenort | Abschlußdatum der Recherche | Prüfer |
|---|---|---|
| Den Haag | 10. Juni 2011 | Simon, Volker |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 10 19 2761

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-06-2011

| Im Recherchenbericht angeführtes Patentdokument | Datum der Veröffentlichung | Mitglied(er) der Patentfamilie | Datum der Veröffentlichung |
|---|---|---|---|
| WO 0186811 A1 | 15-11-2001 | AT 389971 T | 15-04-2008 |
| | | AU 5945701 A | 20-11-2001 |
| | | CA 2408491 A1 | 15-11-2001 |
| | | CN 1436401 A | 13-08-2003 |
| | | DE 60133277 T2 | 23-04-2009 |
| | | EP 1287614 A1 | 05-03-2003 |
| | | HK 1056952 A1 | 03-03-2006 |
| | | JP 2003533118 T | 05-11-2003 |
| | | TW 541789 B | 11-07-2003 |
| | | US 6469564 B1 | 22-10-2002 |

EPO FORM P0461

Für nähere Einzelheiten zu diesem Anhang : siehe Amtsblatt des Europäischen Patentamts, Nr.12/82